(19)

Europäisches
Patentamt
European
Patent Office
Office européen
des brevets

(11) **EP 3 848 923 A1**

(12) **EUROPEAN PATENT APPLICATION**

(43) Date of publication:
**14.07.2021 Bulletin 2021/28**

(51) Int Cl.:
***G09G 3/3225*** (2016.01)

(21) Application number: **20152889.0**

(22) Date of filing: **21.01.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **13.01.2020 CN 202010045178**

(71) Applicant: **Shenzhen Yunyinggu Technology Co., Ltd.**
**Shenzhen 518057 (CN)**

(72) Inventor: **GU, Jing**
**Shenzhen 518057 (CN)**

(74) Representative: **Müller-Boré & Partner**
**Patentanwälte PartG mbB**
**Friedenheimer Brücke 21**
**80639 München (DE)**

(54) **SUBPIXEL ARRANGEMENTS OF DISPLAYS AND METHOD FOR RENDERING THE SAME**

(57) An apparatus including a display panel. In one example, the display includes an array of subpixel groups arranged in columns or rows. The array of subpixel groups includes at least a subpixel group consisting of two subpixels of a first color, one subpixel of a second color, and two subpixels of a third color. In the at least one subpixel group, a distance between the two subpixels of the first color is less than a distance between the two subpixels of the third color, and the distance between the two subpixels of the first color is less than a minimum distance between any two of the subpixels of different colors in the at least one subpixel group.

FIG. 1

**Description**

BACKGROUND

The disclosure relates generally to displays, and more particularly, to subpixel arrangements of displays and a method for rendering the same.

Displays are commonly characterized by display resolution, which is the absolute number of distinct pixels in each dimension that can be displayed (e.g., 1920×1080) or by display density (a.k.a. pixels per inch - PPI) concerning the relative numbers of pixels per inch. Many displays are, for various reasons, not capable of displaying different color channels at the same site. Therefore, the pixel grid is divided into single-color parts that contribute to the displayed color when viewed from a distance. In some displays, such as liquid crystal display (LCD), organic light-emitting diode (OLED) display, electrophoretic ink (E-ink) display, electroluminescent display (ELD) or light-emitting diode (LED) lamp display, these single-color parts are separately addressable elements, which are known as subpixels.

Various subpixel arrangements (layouts, schemes) have been proposed to operate with a proprietary set of subpixel rendering algorithms in order to improve the display quality by increasing the display density of a display and by anti-aliasing text with greater details. For example, LCDs typically divide each pixel into three strip subpixels (e.g., red, green, and blue subpixels) or four quadrate subpixels (e.g., red, green, blue, and white subpixels) so that each pixel can present brightness and a full color. Compared with LCDs, it is even more difficult to increase the display density of OLED displays by reducing the size of individual subpixel because the organic light-emitting layers of OLEDs are fabricated by evaporation techniques using fine metal masks (FMMs). Due to the process accuracy for patterning organic materials using FMMs, the minimum size of each organic light-emitting layer is limited. To overcome such limitation, various subpixel arrangements with subpixel rendering algorithms have been applied to increase the display density of OLED displays.

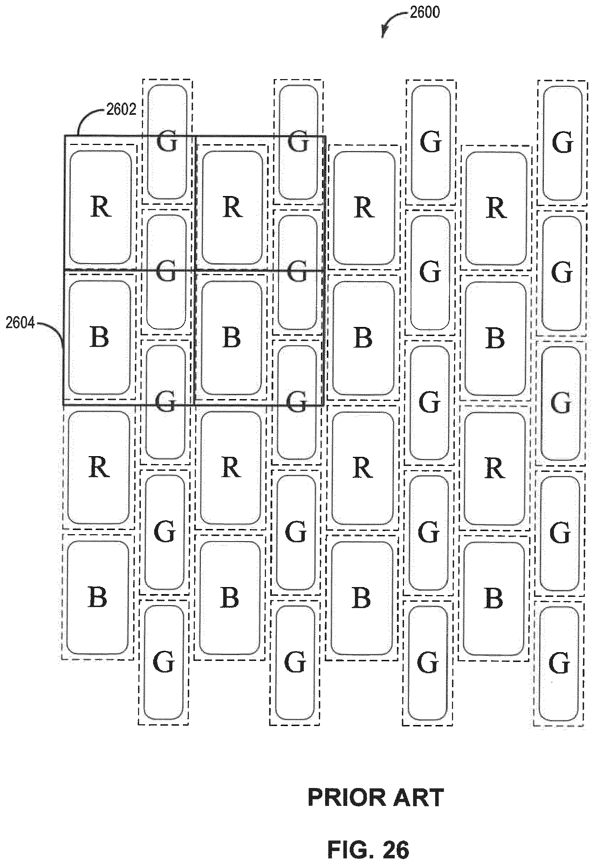

In an OLED display having a "diamond" pixel array 2600 shown in FIG. 26, the green subpixels G are repeated in a single line, while red subpixels R and blue subpixels B are larger and alternate between the lines of green subpixels. The subpixel array 2600 is divided into various pixels, each of which consists of one red subpixel and two half-green subpixels (pixel 2602) or consists of one blue subpixel and two half-green subpixels (pixel 2604). Apparently, in this example, only the number of green subpixels is the same as the number of pixels on the display, while the number of either the red or blue subpixels is only half of the number of pixels in display. That is, the actual color resolution of red or blue subpixels is only half of the display resolution.

Accordingly, there exists a need for improved subpixel arrangements of displays and a method for rendering the same to overcome the above-mentioned problems.

SUMMARY

The present disclosure relates generally to displays, and more particularly, to subpixel arrangements of displays and a method for rendering the same.

In one example, an apparatus, includes a display panel having an array of subpixel groups arranged in columns or rows. The array of subpixel groups includes at least a subpixel group consisting of two subpixels of a first color, one subpixel of a second color, and two subpixels of a third color. In the at least one subpixel group, a distance between the two subpixels of the first color is less than a distance between the two subpixels of the third color, and the distance between the two subpixels of the first color is less than a minimum distance between any two of the subpixels of different colors in the at least one subpixel group.

In another example, an apparatus includes a display having a display panel. The display panel includes a light-emitting substrate having an array of subpixel groups arranged in columns or rows, a subpixel in each of the subpixel groups corresponding to an organic light-emitting diode (OLED), and a driving substrate having an array of driving elements, each driving element configured to drive a respective OLED. The control logic is operatively coupled to the display and configured to receive display data and convert the display data into control signals for driving the array of subpixel groups. The array of subpixel groups includes at least a subpixel group consisting of two OLEDs of a first color, one OLED of a second color, and two OLEDs of a third color, each of the OLEDs comprising a respective pair of anode and cathode. In the at least one subpixel group, a distance between the two OLEDs of the first color is less than a distance between the two OLEDs of the third color, the distance between the two OLEDs of the first color is less than a minimum distance between any two of the OLEDs of different colors in the at least one subpixel group, and the two OLEDs of the first color sharing a same organic light-emitting layer.

BRIEF DESCRIPTION OF THE DRAWINGS

The embodiments will be more readily understood in view of the following description when accompanied by the below figures and wherein like reference numerals represent like elements, wherein:

FIG. 1 is a block diagram illustrating an apparatus including a display and control logic in accordance with one embodiment set forth in the disclosure;
FIG. 2 is a side-view diagram illustrating one example of the display shown in FIG. 1 in accordance with one embodiment set forth in the disclosure;
FIG. 3 is a depiction of a subpixel arrangement of a display in accordance with one embodiment set forth in the disclosure;

FIG. 4 is a depiction of a red, green, and blue subpixel arrangement of an OLED display in accordance with one embodiment set forth in the disclosure;

FIG. 5 is a side-view diagram illustrating an organic light-emitting layer shared by two subpixels in accordance with one embodiment set forth in the disclosure;

FIG. 6 is a depiction of masks used for fabricating organic light-emitting layers of the red, green, and blue OLEDs shown in FIG. 4 in accordance with one embodiment set forth in the disclosure;

FIG. 7 is a schematic diagram of pixel division for the subpixel arrangement shown in FIG. 4 in accordance with one embodiment set forth in the disclosure;

FIG. 8 is a schematic diagram of one example of wire layout for the subpixel arrangement shown in FIG. 4 in accordance with one embodiment set forth in the disclosure;

FIG. 9 is a schematic diagram of another example of wire layout for the subpixel arrangement shown in FIG. 4 in accordance with one embodiment set forth in the disclosure;

FIG. 10 is a schematic diagram of still another example of wire layout for the subpixel arrangement shown in FIG. 4 in accordance with one embodiment set forth in the disclosure;

FIG. 11 is a depiction of displaying a white screen on a display using the subpixel arrangement shown in FIG. 4 in accordance with one embodiment set forth in the disclosure;

FIG. 12 is a depiction of displaying a single green vertical line on a display using the subpixel arrangement shown in FIG. 4 in accordance with one embodiment set forth in the disclosure;

FIG. 13 is a depiction of displaying two adjacent green vertical lines on a display using the subpixel arrangement shown in FIG. 4 in accordance with one embodiment set forth in the disclosure;

FIG. 14 is a depiction of displaying two separate green vertical lines on a display using the subpixel arrangement shown in FIG. 4 in accordance with one embodiment set forth in the disclosure;

FIG. 15 is a depiction of displaying a single blue vertical line on a display using the subpixel arrangement shown in FIG. 4 in accordance with one embodiment set forth in the disclosure;

FIG. 16 is a depiction of displaying two adjacent blue vertical lines on a display using the subpixel arrangement shown in FIG. 4 in accordance with one embodiment set forth in the disclosure;

FIG. 17 is a depiction of displaying two separate blue vertical lines on a display using the subpixel arrangement shown in FIG. 4 in accordance with one embodiment set forth in the disclosure;

FIG. 18 is a depiction of a subpixel arrangement of an LED lamp display in accordance with one embodiment set forth in the disclosure;

FIG. 19 is a schematic diagram of pixel division for the subpixel arrangement shown in FIG. 18 in accordance with one embodiment set forth in the disclosure;

FIG. 20 is a flow chart illustrating a method for rendering subpixels of the display shown in FIG. 1 in accordance with one embodiment set forth in the disclosure;

FIG. 21 is a schematic diagram illustrating an algorithm for implementing the method shown in FIG. 20 in accordance with one embodiment set forth in the disclosure;

FIG. 22 is a depiction of another subpixel arrangement of an OLED display in accordance with one embodiment set forth in the disclosure;

FIG. 23 is a depiction of still another subpixel arrangement of an OLED display in accordance with one embodiment set forth in the disclosure;

FIG. 24 is a diagram illustrating one example of implementing the control logic shown in FIG. 1 as an integrated circuit (IC) chip in accordance with one embodiment set forth in the disclosure;

FIG. 25 is a diagram illustrating another example of implementing the control logic shown in FIG. 1 as an IC chip in accordance with one embodiment set forth in the disclosure;

FIG. 26 is a depiction of a prior art red, green, and blue subpixel arrangement of an OLED display;

FIGs. 27A-27D each is a depiction of another subpixel arrangement of a display in accordance with one embodiment set forth in the discloure;

FIGs. 28A and 28B each is another depiction of a red, green, and blue subpixel arrangement of an OLED display in accordance with one embodiment set forth in the disclosure;

FIGs. 29A and 29B each is another depiction of a red, green, and blue subpixel arrangement of an OLED display in accordance with one embodiment set forth in the disclosure;

FIGs. 30A and 30B each is another depiction of a red, green, and blue subpixel arrangement of an OLED display in accordance with one embodiment set forth in the disclosure;

FIGs. 31A and 31B each is another depiction of a red, green, and blue subpixel arrangement of an OLED display in accordance with one embodiment set forth in the disclosure;

FIG. 32A is a depiction of a mask used for fabricating organic light-emitting layers of the red, green, and blue OLEDs shown in FIG. 28A in accordance with one embodiment set forth in the disclosure;

FIG. 32B is a depiction of a mask used for fabricating electrodes shown in FIG. 28A in accordance with one embodiment set forth in the disclosure; and

FIGs. 33A and 33B each is another depiction of a red, green, and blue subpixel arrangement of an OLED display in accordance with one embodiment set forth in the disclosure.

DETAILED DESCRIPTION

In the following detailed description, numerous specific details are set forth by way of examples in order to provide a thorough understanding of the relevant disclosures. However, it should be apparent to those skilled in the art that the present disclosure may be practiced without such details. In other instances, well known methods, procedures, systems, components, and/or circuitry have been described at a relatively high-level, without detail, in order to avoid unnecessarily obscuring aspects of the present disclosure.

Among other novel features, the present disclosure provides the ability to further increase the actual color resolution by overcoming the limitations of mask-based organic materials evaporation techniques. The novel subpixel arrangements of the present disclosure are fully compatible with existing fabrication techniques and thus, ensure the relative high yield and low production cost. The novel subpixel arrangements of the present disclosure also make the color distribution of the display more uniform compared with known solutions, thereby increasing the user experience. The novel subpixel arrangements of the present disclosure can be applied to various displays, such as but not limited to, top-emitting OLED displays, bottom-emitting OLED displays, or billboard displays with lamps.

Additional novel features will be set forth in part in the description which follows, and in part will become apparent to those skilled in the art upon examination of the following and the accompanying drawings or may be learned by production or operation of the examples. The novel features of the present disclosure may be realized and attained by practice or use of various aspects of the methodologies, instrumentalities, and combinations set forth in the detailed examples discussed below.

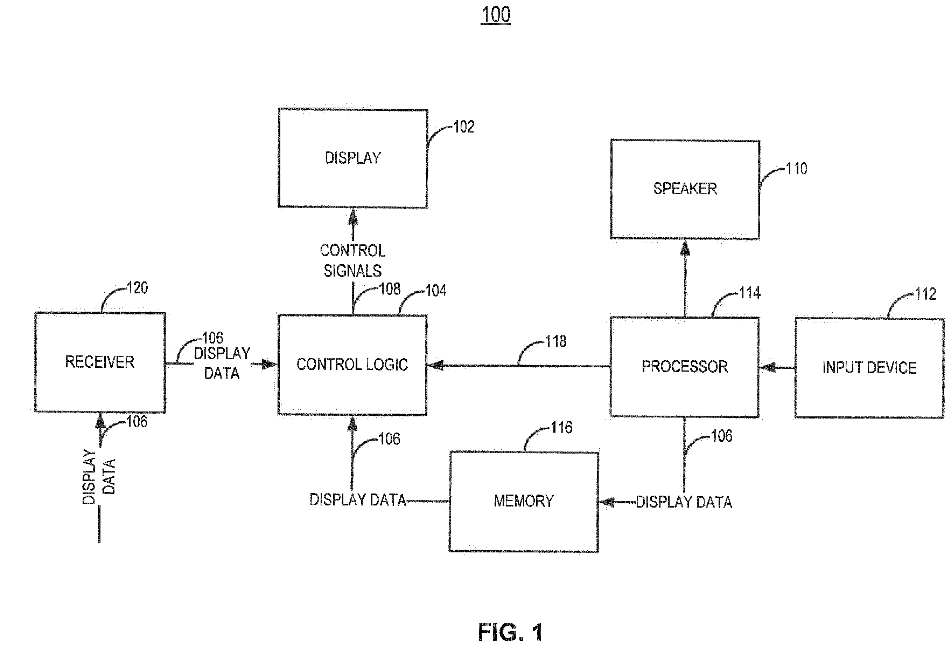

FIG. 1 illustrates an apparatus 100 including a display 102 and control logic 104. The apparatus 100 may be any suitable device, for example, a television set, laptop computer, desktop computer, netbook computer, media center, handheld device (e.g., dumb or smart phone, tablet, etc.), electronic billboard, electronic sign, gaming console, set-top box, printer, or any other suitable device. In this example, the display 102 is operatively coupled to the control logic 104 and is part of the apparatus 100, such as but not limited to, a television screen, computer monitor, dashboard, head-mounted display, electronic billboard, or electronic sign. The display 102 may be an LCD, OLED display, E-ink display, ELD, billboard display with LED or incandescent lamps, or any other suitable type of display. The control logic 104 may be any suitable hardware, software, firmware, or combination thereof, configured to receive display data 106 and render the received display data 106 into control signals 108 for driving the subpixels on the display 102. For example, subpixel rendering algorithms for various subpixel arrangements may be part of the control logic 104 or implemented by the control logic 104. The control logic 104 may include any other suitable components, including an encoder, a decoder, one or more processors, controllers (e.g., timing controller), and storage devices. The control logic 104 may be implemented as a standalone integrated circuit (IC) chip or part of the driving circuits of the display 102. One example of the control logic 104 and a method for rendering subpixels of the display 102 implemented by the control logic 104 are described below in detail. The apparatus 100 may also include any other suitable component such as, but not limited to, a speaker 110 and an input device 112, e.g., a mouse, keyboard, remote controller, handwriting device, camera, microphone, scanner, etc.

In one example, the apparatus 100 may be a laptop or desktop computer having a display 102. In this example, the apparatus 100 also includes a processor 114 and memory 116. The processor 114 may be, for example, a graphic processor (e.g., GPU), a general processor (e.g., APU, accelerated processing unit; GPGPU, general-purpose computing on GPU), or any other suitable processor. The memory 116 may be, for example, a discrete frame buffer or a unified memory. The processor 114 is configured to generate display data 106 in display frames and temporally store the display data 106 in the memory 116 before sending it to the control logic 104. The processor 114 may also generate other data, such as but not limited to, control instructions 118 or test signals, and provide them to the control logic 104 directly or through the memory 116. The control logic 104 then receives the display data 106 from the memory 116 or from the processor 114 directly.

In another example, the apparatus 100 may be a television set having a display 102. In this example, the apparatus 100 also includes a receiver 120, such as but not limited to, an antenna, radio frequency receiver, digital signal tuner, digital display connectors, e.g., HDMI, DVI, DisplayPort, USB, Bluetooth, WiFi receiver, or Ethernet port. The receiver 120 is configured to receive the display data 106 as an input of the apparatus 100 and provide the native or modulated display data 106 to the control logic 104.

In still another example, the apparatus 100 may be a handheld device, such as a smart phone or a tablet. In this example, the apparatus 100 includes the processor 114, memory 116, and the receiver 120. The apparatus 100 may both generate display data 106 by its processor 114 and receive display data 106 through its receiver 120. For example, the apparatus 100 may be a handheld device that works as both a mobile television and a mobile computing device. In any event, the apparatus 100 at least includes the display 102 with specifically designed subpixel arrangements as described below in detail and the control logic 104 for the specifically designed subpixel arrangements of the display 102.

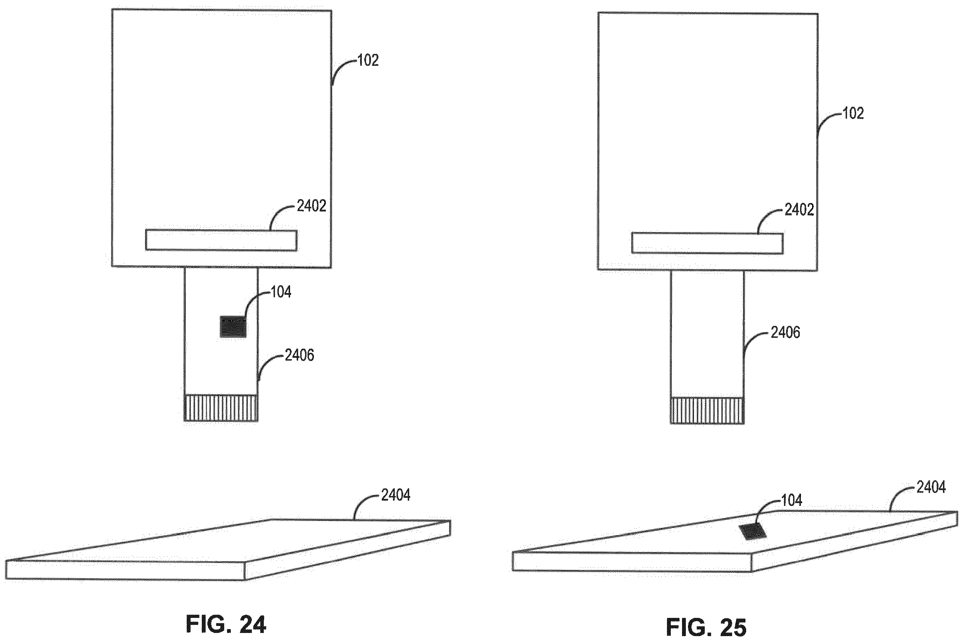

Referring now to FIGS. 24 and 25, the control logic 104 is implemented as a standalone IC chip in these examples, such as a field-programmable gate array (FPGA) or an application-specific integrated circuit (ASIC). In one example illustrated in FIG. 24, the apparatus 100 is a handheld device such as a smartphone or a tablet, which includes the display 102 with driving circuits 2402 and a motherboard 2404. The display 102 is connected to the motherboard 2404 through a flexible printed circuit (FPC) 2406. The IC chip implementing the control logic 104 is arranged on the FPC 2406 such that the handheld device can be easily integrated with the control logic 104 without changing the motherboard 2404. In another example illustrated in FIG. 25, the IC chip implementing the control logic 104 is arranged on the motherboard 2404 to reduce the cost of the handheld device.

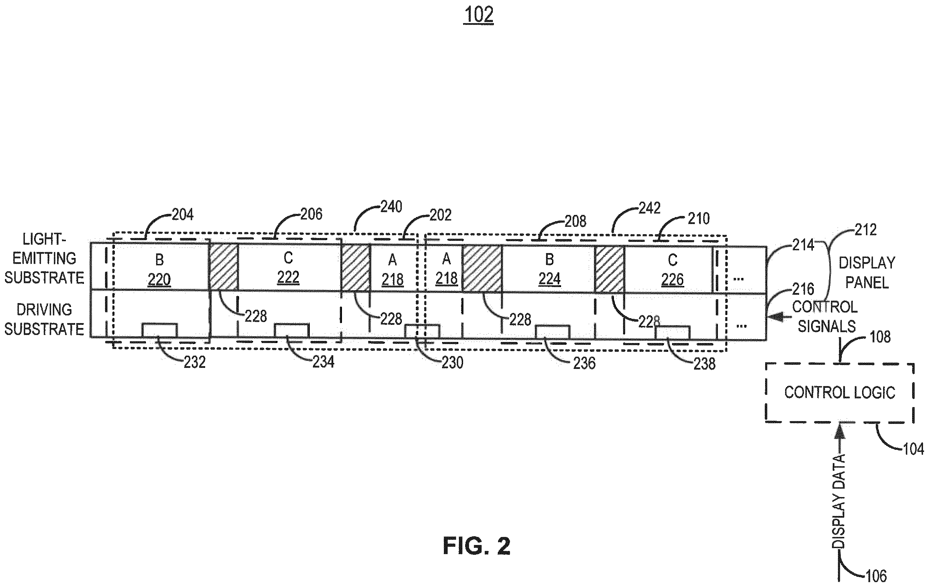

FIG. 2 illustrates one example of a display 102 including a group of subpixels 202, 204, 206, 208, 210. The display 102 may be any suitable type of display, for example, OLED displays, such as an active-matrix (AM) OLED display, passive-matrix (PM) OLED display, or any other suitable display. The display 102 may include a display panel 212 operatively coupled to the control logic 104.

In this example, the display panel 212 includes a light-emitting substrate 214 and a driving substrate 216. As shown in FIG. 2, the light-emitting substrate 214 includes a plurality of OLEDs 218, 220, 222, 224, 226 corresponding to the plurality of subpixels 202, 204, 206, 208, 210, respectively. A, B, and C in FIG. 2 denote OLEDs in three different colors, such as but not limited to, red, green, blue, yellow, cyan, magenta, or white. The light-emitting substrate 214 also includes a black matrix 228 disposed between the OLEDs 218, 220, 222, 224, 226, as shown in FIG. 2. The black matrix 228, as the borders of the subpixels 202, 204, 206, 208, 210, is used for blocking lights coming out from the parts outside the OLEDs 218, 220, 222, 224, 226. Each OLED 218, 220, 222, 224, 226 in the light-emitting substrate 214 can emit light in a predetermined color and brightness. In this example, the driving substrate 216 includes a plurality of driving elements 230, 232, 234, 236, 238, such as thin film transistors (TFTs), corresponding to the plurality of OLEDs 218, 220, 222, 224, 226 of the plurality of subpixels 202, 204, 206, 208, 210, respectively. The driving elements 230, 232, 234, 236, 238 may be individually addressed by the control signals 108 from the control logic 104 and are configured to drive the corresponding subpixels 202, 204, 206, 208, 210, by controlling the light emitting from the respective OLEDs 218, 220, 222, 224, 226 according to the control signals 108. The display panel 212 may include any other suitable component, such as one or more glass substrates, polarization layers, or a touch panel, as known in the art.

As shown in FIG. 2, each of the plurality of subpixels 202, 204, 206, 208, 210 is constituted by at least an OLED and a corresponding driving element. Each OLED may be formed by a sandwich structure of an anode, an organic light-emitting layer, and a cathode, as known in the art. Depending on the characteristics (e.g.,

material, structure, etc.) of the organic light-emitting layer of the respective OLED, a subpixel may present a distinct color and brightness. In this example, subpixels 202, 204, 206, 208, 210, as a subpixel group, are divided into two pixels. The first pixel 240 includes subpixel B 204 and subpixel C 206, the second pixel 242 includes subpixel B 208 and subpixel C 210, and subpixel A 202 is shared by both the first and second pixels 240, 242. Here, since the display data 106 is usually programmed at the pixel level, the subpixels of each pixel or the multiple subpixels of adjacent pixels may be addressed collectively by subpixel rendering to present the appropriate brightness and color of each pixel, as designated in the display data 106, with the help of subpixel rendering algorithms. However, it is understood that, in other examples, the display data 106 may be programmed at the subpixel level such that the display data 106 can directly address individual subpixel without the need of subpixel rendering. Because it usually requires three primary colors - RGB to present a full color, specifically designed subpixel arrangements are provided below in detail for the display 102 to achieve an appropriate actual color resolution.

Although FIG. 2 is illustrated as an OLED display, it is understood that it is provided for an exemplary purpose only and without limitations. As noted above, in addition to an OLED display, the display 102 may be an LCD, E-ink display, ELD, billboard display with LED or incandescent lamps, or any other suitable type of display.

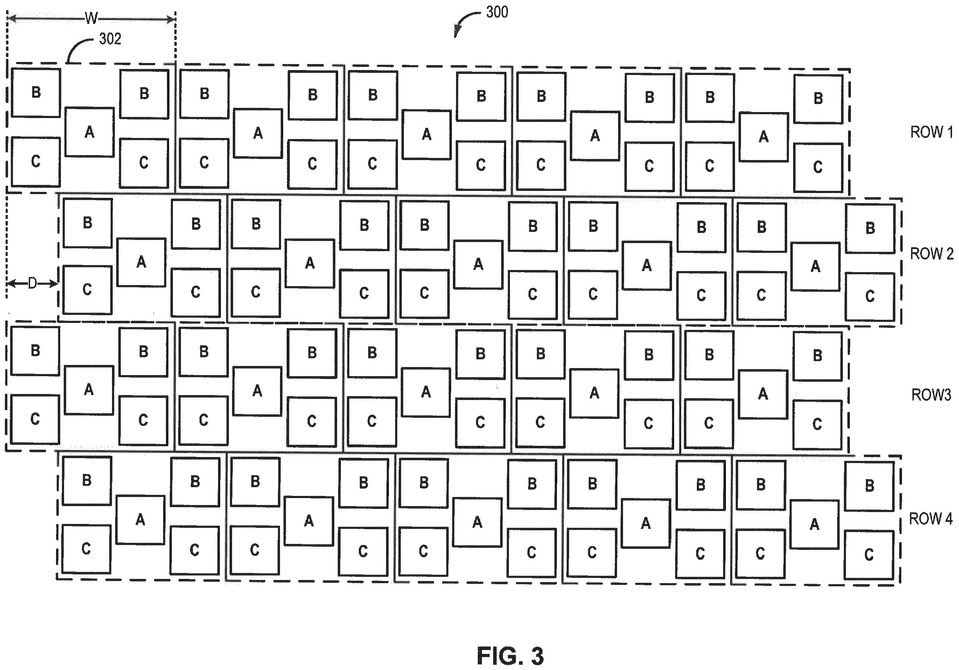

FIG. 3 depicts a subpixel arrangement of a display in accordance with one embodiment set forth in the disclosure. FIG. 3 may be, for example, a plan view of the display 102 and depicts one example of subpixel arrangements of the display 102. The display 102 includes an array 300 of subpixel groups 302. Each subpixel group 302 in this embodiment includes five subpixels: one subpixel in a first color A, two subpixels in a second color B, and two subpixels in a third color C. A, B, and C in FIG. 3 denote three different colors, such as but not limited to, red, green, blue, yellow, cyan, magenta, or white. Subpixel groups 302 in each row (e.g., Row 1, Row 2, Row 3, Row 4, etc.) of the array 300 are repeated along the horizontal direction. Subpixel groups 302 in each row of the array 300 are staggered relative to subpixels groups 302 in an adjacent row of the array 300. In other words, subpixel groups 302 in adjacent rows are staggered along the horizontal direction. For example, as shown in FIG. 3, subpixel groups 302 in Row 1 are staggered relative to subpixel groups 302 in Row 2 by a distance of D. It is understood that the distance D is less than the width W of the subpixel group 302. In one example, the distance D equals ½ of the width W of the subpixel group 302. In this embodiment, subpixel groups 302 in interval rows are aligned along the vertical direction. That is, subpixel groups 302 in each odd row (e.g., Row 1, Row 3, etc.) are aligned along the vertical direction, and subpixel groups 302 in each even row (e.g., Row 2, Row 4, etc.) are aligned along the vertical direction. Stated in another way, subpixel groups 302 in each row are arranged repeatedly, and the subpixel groups 302 in adjacent rows are arranged shifted from each other by, for example, ½ of the repeat pitch.

In this embodiment, the five subpixels A, B, B, C, and C are arranged in the same pattern in each subpixel group 302. For each subpixel group 302, the two subpixels in the second color B are on different sides of the subpixel in the first color A along the horizontal direction, and the two subpixels in the third color C are on different sides of the subpixel in the first color A along the horizontal direction as well. That is, in the horizontal direction, subpixel A is between the two subpixels B and also between the two subpixels C. In other words, in each subpixel group 302, one subpixel B and one subpixel C are in the left part of the subpixel group 302, the other subpixel B and the other subpixel C are in the right part of the subpixel group 302, and the subpixel A is in the middle of the subpixel group 302.

In this embodiment, in each subpixel group 302, one subpixel B is aligned with one subpixel C along the vertical direction on the left side of the subpixel A, and the other subpixel B is aligned with the other subpixel C along the vertical direction on the right side of the subpixel A. The two subpixels B are aligned along the horizontal direction, and the two subpixels C are aligned along the horizontal direction as well. In other words, the two subpixels in the same colors (i.e., B and B, or C and C) are arranged flush with each other horizontally, and the two subpixels in the different colors (i.e., B and C) are arranged flush with each other vertically. It is understood that even if two subpixels have different sizes and/or shapes, they are considered as being "aligned" if the centers of the two subpixels are aligned vertically or horizontally.

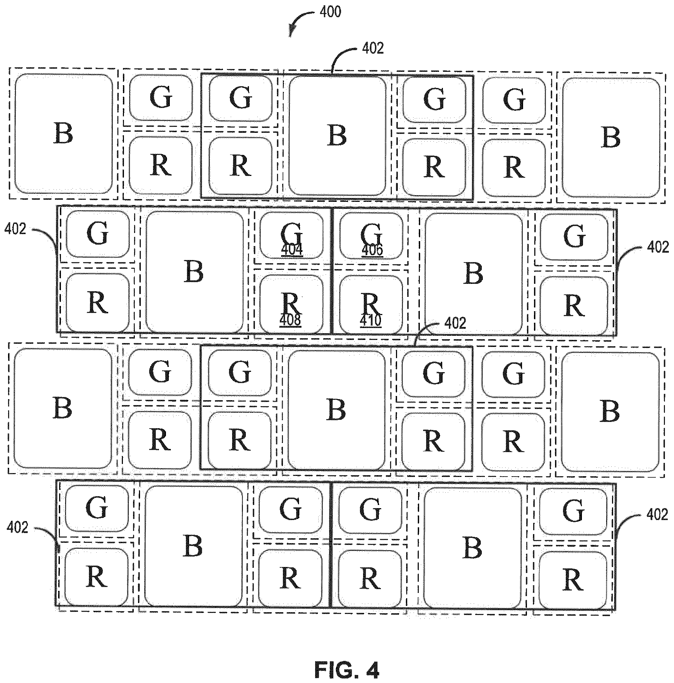

FIG. 4 depicts a red, green, and blue subpixel arrangement of an OLED display in accordance with one embodiment set forth in the disclosure. FIG. 4 may be, for example, a plan view of the display 102 and depicts one example of subpixel arrangements of the display 102. In this embodiment, each subpixel corresponds to an OLED. The same subpixel arrangement illustrated with respect to FIG. 3 is applied to the array 400 of subpixel groups 402 in this example. As shown in FIG. 4, each subpixel group 402 includes one blue OLED B, two green OLEDs G, and two red OLEDs R. In this embodiment, subpixel groups 402 are repeated horizontally in the same row and are staggered relative to subpixel groups 402 in the adjacent row by half of the width of the subpixel group 402. In each subpixel group 402, one green OLED and one red OLED are disposed on the left side of the blue OLED, and the other green OLED and the other red OLED are disposed on the right side of the blue OLED. It is understood that although FIG. 4 shows that the green OLEDs are above the red OLEDs in each subpixel group 402, their positions may be exchanged in other examples. In other words, the red OLEDs may be above the blue OLEDs in each subpixel group 402.

In this embodiment, the size of the blue OLED is larger than the size of any one of the two green OLEDs and the two red OLEDs. Stated in another way, the blue OLED is the largest subpixel among the five subpixels in each subpixel group 402. In this embodiment, each subpixel has a substantially rectangular shape with curved corners. However, it is understood that the shape of each subpixel in other examples may vary. Other shapes of the subpixels include, but are not limited to, substantially round, triangle, square, pentagon, hexagon, heptagon, octagon, or any other suitable shape. The regions between the subpixels may be filled with the black matrix as noted above. In this embodiment, the two green OLEDs in each subpixel group 402 have the same shape and size, and the two red OLEDs have the same shape and size as well. In other words, subpixels in the same color in each subpixel group 402 are geometrically identical. In one example, each of the two green OLEDs and two red OLEDs has the same shape and size. That is, except for the largest blue subpixel, each of the subpixels in the subpixel group 402 is geometrically identical in one example. It is understood that, in other examples, each subpixel group may include one red OLED, two green OLEDs, and two blue OLEDs, and the red OLED is in the middle of the subpixel group and has the largest size among the five OLEDs in the subpixel group.

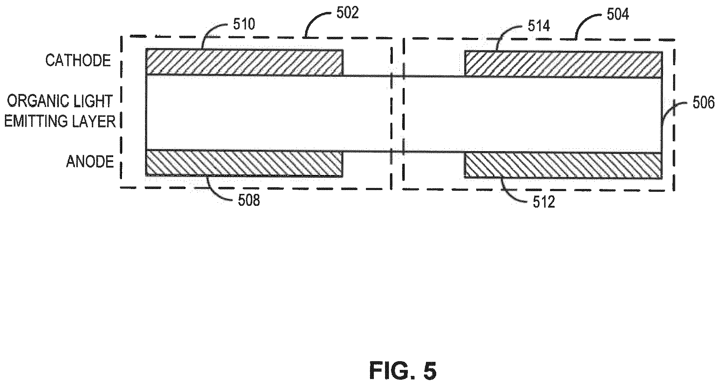

In this embodiment, each of the two green OLEDs in a subpixel group 402 shares the same organic light-emitting layer with a respective green OLED in the adjacent subpixel group 402 in the same row of the array 400. Similarly, each of the red OLEDs in one subpixel group 402 shares the same organic light-emitting layer with a respective red OLED in the adjacent subpixel group 402 in the same row. The dashed lines in FIG. 4 show the regions of organic light-emitting layers. For example, the green OLED 404 and the green OLED 406 in the two adjacent subpixel groups 402 share the same organic light-emitting layer, so do the red OLEDs 408, 410. That is, a common organic light-emitting layer is used by adjacent OLEDs in the same color. Referring now to FIG. 5, a first OLED 502 and a second OLED 504 in the same color are adjacent to each other and share the same organic light-emitting layer 506. Although the two adjacent OLEDs 502, 504 share the same organic light-emitting layer 506, they are distinguishable by separate anodes and/or cathodes. In this example, the first OLED 502 has its own anode 508 and cathode 510 for applying current through the organic light-emitting layer 506, and the second OLED 504 has its own anode 512 and cathode 514 as well. It is understood that in other examples, the two OLEDs 502, 504 may also share the same anode or cathode.

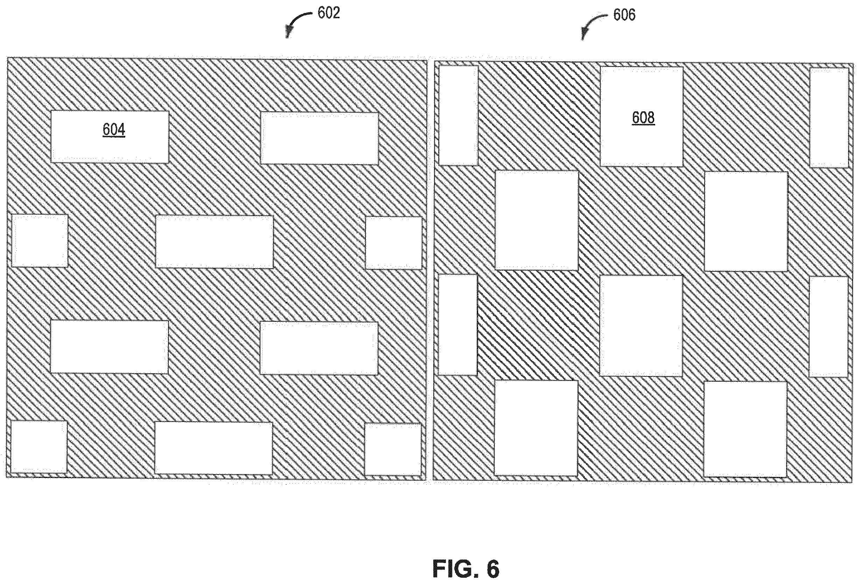

As discussed above, the bottle neck of increasing the pixel density of OLED displays is the minimum size of each organic light-emitting layer limited by the pattern accuracy of masks used in organic materials evaporation. In this embodiment, this limitation is further overcome because the blue OLED has a relative large size and the adjacent green/red pixels can share a common organic light-emitting layer with a relative large size. Referring now to FIG. 6, masks (e.g., FMMs) used for fabricating organic light-emitting layers of the red, green, and blue OLEDs shown in FIG. 4 are illustrated. The first mask 602 is used for fabricating the organic light-emitting layers of the red or green OLEDs by evaporation technique. Each opening 604 on the first mask 602 corresponds to a common organic light-emitting layer shared by two adjacent red or green OLEDs. The layout of the openings 604 corresponds to the arrangement of the green or red subpixels shown in FIG. 4. The second mask 606 is used for fabricating the organic light-emitting layers of the blue OLEDs. Each opening 608 on the second mask 606 corresponds to the organic light-emitting layer of each blue OLED. The layout of the openings 608 corresponds to the arrangement of the blue subpixels shown in FIG. 4. It is understood that in other examples, the first mask 602 may be used for fabricating the organic light-emitting layers of the blue or green OLEDs, and the second mask 606 may be used for fabricating the organic light-emitting layers of the red OLEDs.

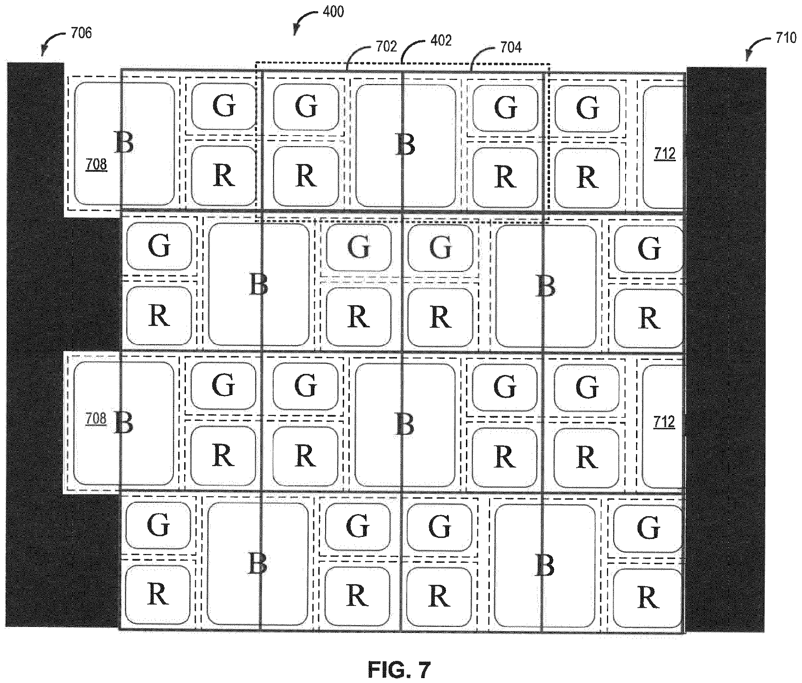

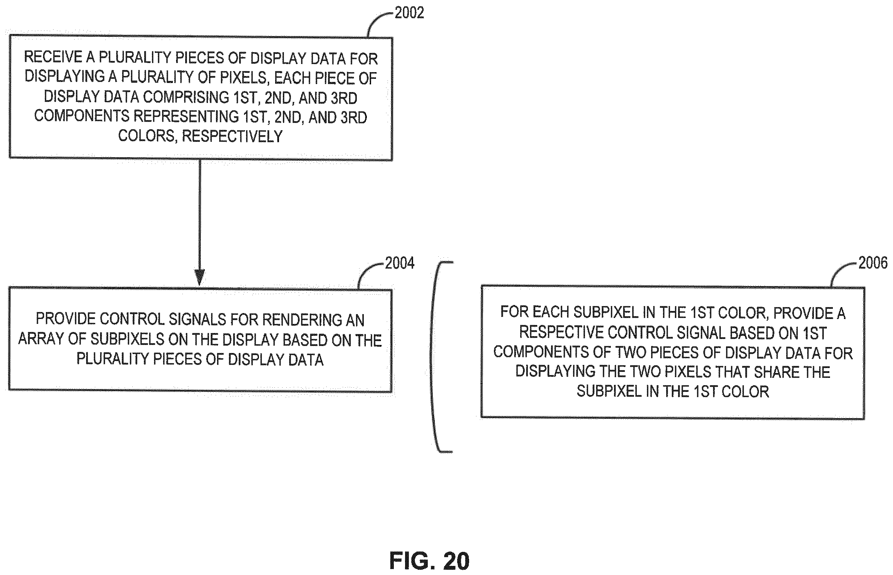

FIG. 7 illustrates one example of pixel division for the subpixel arrangement shown in FIG. 4. In this example, each subpixel group 402 is divided into two pixels 702, 704 such that, each of the two pixels 702, 704 includes one of the two subpixels in the second color (e.g., G) and one of the two subpixels in the third color (e.g., R), and that the subpixel in the first color (e.g., B) is shared by the two pixels 702, 704. As shown in FIG. 7, the subpixel group 402 is evenly divided through the middle of the blue OLED into a left part corresponding to one pixel 702, and a right part corresponding to another pixel 704. The pixel 702 includes one green OLED, one red OLED, and the left part of the blue OLED; the pixel 704 includes one green OLED, one red OLED, and the right part of the blue OLED. That is, each blue OLED on the display is shared by two adjacent pixels. As each blue OLED has only one organic light-emitting layer and one set of anode/cathode, it is necessary to implement a special subpixel rendering algorithm in the control logic 104 when the blue OLED is shared by two pixels. The details of the subpixel rendering algorithm are described below with respect to FIGS. 20-21. In this example, the numbers of green and red subpixels are the same as the number of pixels on the display, and only the number of the blue subpixels is half of the number of pixels on the display. Therefore, compared with the prior art example shown in FIG. 26, the actual color resolution in this embodiment is increased. Moreover, each pixel 702, 704 in this embodiment includes all three primary colors - RGB, which is also superior over the prior art example shown in FIG. 26.

In this embodiment, due to the staggered arrangement between adjacent rows, the left and right edges of the display become irregular. In one example, a black resin layer with a serrated edge 706 is used to cover the edges of the display such that the size and shape of the blue OLEDs 708 along the edges do not change. In this example, the same subpixel rendering algorithm can be applied to all the blue OLEDs including those 708 along the edges of the display. However, the serrated shape along the edges of the display is undesirable, in particular, when the size of each pixel is relative large. In another example, a black resin layer with a flat edge 710 is used to cover the edges of the display such that each blue OLED 712 along the edges is only half of a regular blue OLED. In this example, the subpixel rendering algorithm needs to be modified to render the blue OLEDs 712 along the edges of the display differently. For example, each blue OLED 712 along the edges is no longer shared by two pixels; rather it is included in only one pixel. Thus, the special treatment for the blue OLEDs may not be necessary for those 712 along the edges of the display. It is understood that, in other examples, the red OLED, rather than the blue OLED, may be the largest OLED and in the middle of each subpixel group, which is shared by two adjacent pixels.

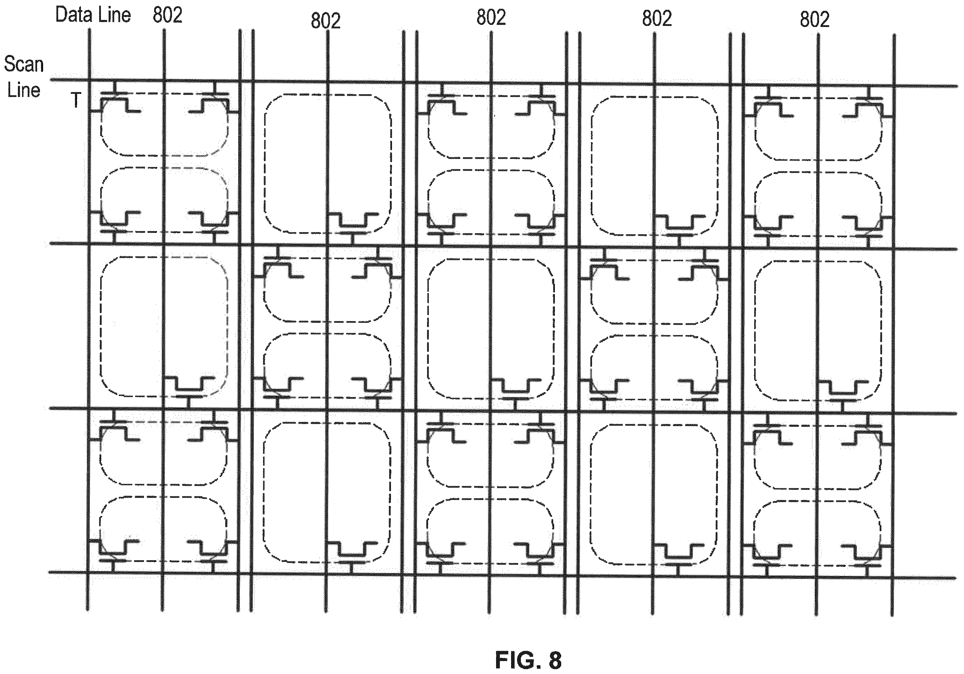

FIG. 8 depicts one example of wire layout for the subpixel arrangement shown in FIG. 4. In this example, the dashed lines illustrate the regions of organic light-emitting layers, and T is the switching transistor (e.g., a TFT) for each OLED. In this example, those data lines 802 passing through the blue or red OLEDs (the largest OLED in the middle of each subpixel group) are used only for transmitting data of blue or red subpixels. Thus, the signal duty ratio of the data lines in this example is only 50%, with half of the frames are blank. Accordingly, the bandwidth of the display data cannot be reduced in this example. However, the wire layout in this example is particular suitable for bottom-emitting OLED displays as this layout can increase the aperture ratio of bottom-emitting OLED displays.

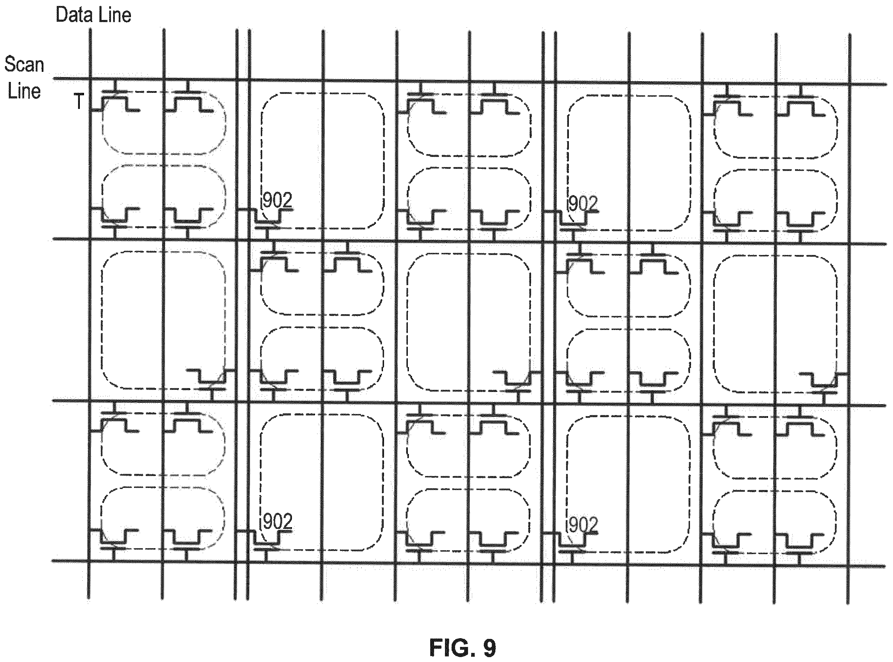

FIG. 9 depicts another example of wire layout for the subpixel arrangement shown in FIG. 4. In this example, the dashed lines illustrate the regions of organic light-emitting layers, and T is the switching transistor for each OLED. In this example, the number of data lines is reduced compared with the example in FIG. 8 such that the signal duty ratio of each data line increases to 100%, thereby reducing the bandwidth of the display data, reducing the width of IC, and reducing the number of source pins. However, as some switching transistors 902 of the blue or red OLEDs (the largest OLED in the middle of each subpixel group) cross adjacent data lines, anti-coupling issues need to addressed in layout design.

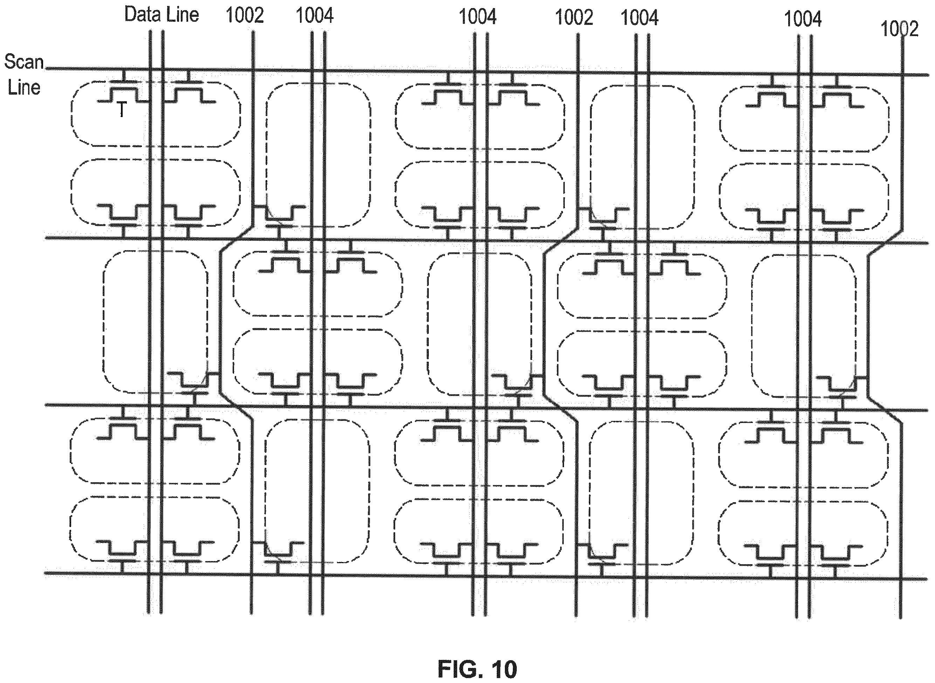

FIG. 10 depicts still another example of wire layout for the subpixel arrangement shown in FIG. 4. In this example, the dashed lines illustrate the regions of organic light-emitting layers, and T is the switching transistor for each OLED. As the OLEDs in different colors have different sizes, the edges between organic light-emitting layers are not aligned in the vertical direction. Thus, in this example, some data lines 1002 are polygonal lines that extend along the edges of organic light-emitting layers. These polygonal data lines 1002 in this example are all single data lines. Other data lines 1004 passing through the blue or red OLEDs (the largest OLED in the middle of each subpixel group) are double straight lines as shown in FIG. 10. Similar to the example in FIG. 9, the number of data lines is reduced compared with the example in FIG. 8 such that the signal duty ratio of each data line increases to 100%, thereby reducing the bandwidth of the display data, reducing the width of IC, and reducing the number of source pins.

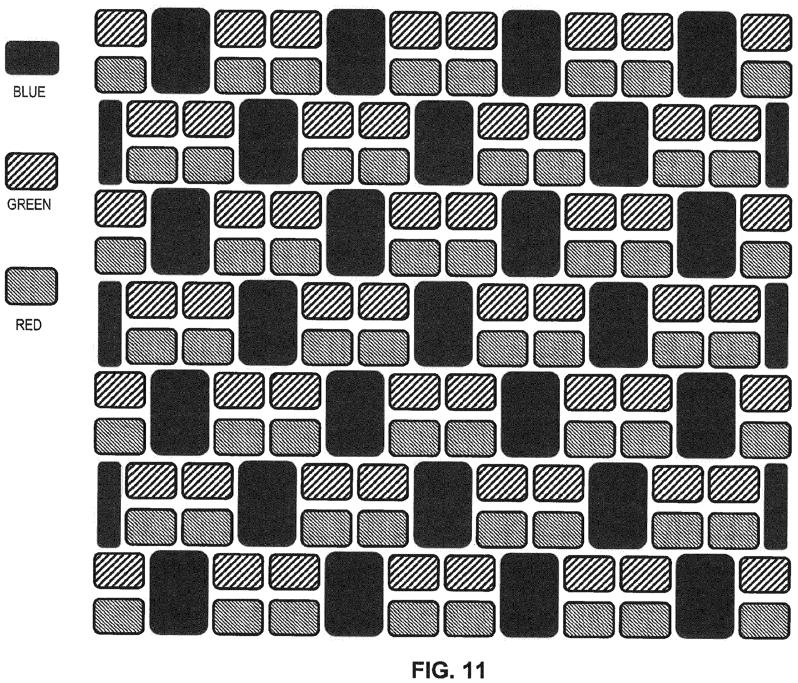

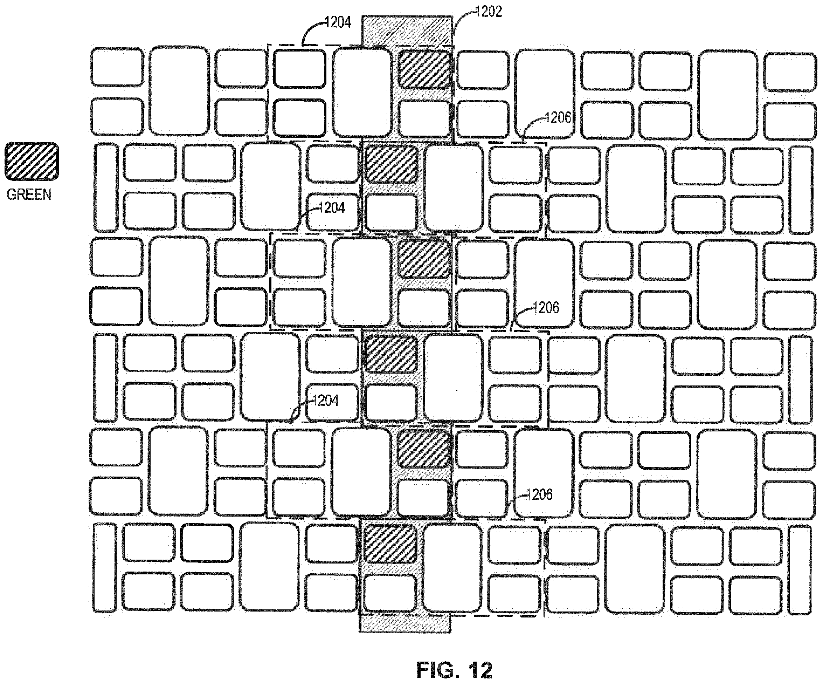

FIGS. 11-17 depict various examples of displaying different patterns on a display using the subpixel arrangement shown in FIG. 4. In FIG. 11, each subpixel is fully turned on (i.e., the value of each subpixel is 255), and a white screen is displayed. In FIG. 12, a single green vertical line 1202 is displayed by fully turning on half of the green subpixels (i.e., the value of the green subpixel is 255) in the corresponding subpixel groups 1204, 1206. For example, in each odd row of subpixels, the green subpixels in the right part of the corresponding subpixel groups 1204 are turned on; in each even row of subpixels, the green subpixels in the left part of the corresponding subpixel groups 1206 are turned on. It is understood that because of the staggered arrangement between adjacent rows, the green subpixels in adjacent rows are not strictly aligned in the vertical direction and thus, the single green vertical line 1202 in this example is not a straight line. However, the human vision system would consider the single green vertical line 1202 as a straight line when viewed from a distance.

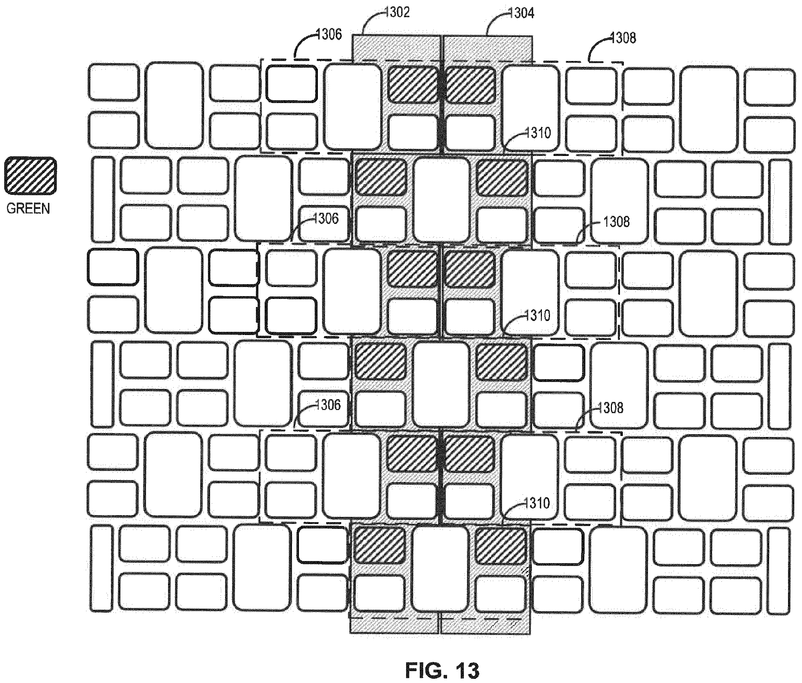

In FIG. 13, two adjacent green vertical lines 1302, 1304 are displayed by fully turning on half or all of the green subpixels (i.e., the value of the green subpixel is 255) in the corresponding subpixel groups 1306, 1308, 1310. In each odd row of subpixels, half of the green subpixels in the two adjacent subpixel groups 1306, 1308 are turned on. For example, the green subpixels in the right part of the corresponding subpixel groups 1306 in each odd row are turned on, and the green subpixels in the left side of the corresponding subpixel groups 1308 in each odd row are turned on. Subpixel groups 1306 and subpixel groups 1308 are adjacent to each other in each odd row. In each even row, all the green subpixels in the corresponding subpixel groups 1310 are turned on. Similarly, the human vision system would consider the two adjacent green vertical lines 1302, 1304 as two straight lines when viewed from a distance.

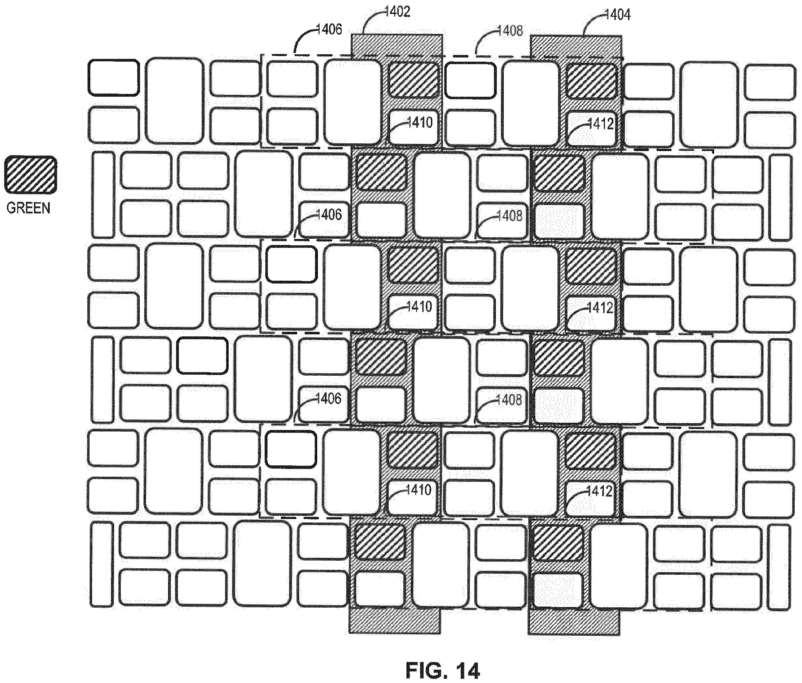

In FIG. 14, two separate green vertical lines 1402, 1404 are displayed by fully turning on half of the green subpixels (i.e., the value of the green subpixel is 255) in the corresponding subpixel groups 1406, 1408, 1410, 1412. In each odd row of subpixels, half of the green subpixels in the two adjacent subpixel groups 1406, 1408 are turned on; in each even row of subpixels, half of the green subpixels in the two adjacent subpixel groups 1410, 1412 are turned on. For example, the green subpixels in the right part of the corresponding subpixel groups 1406, 1408 in each odd row are turned on, and the green subpixels in the left part of the corresponding subpixel groups 1410, 1412 in each even row are turned on. Subpixel groups 1406 and subpixel groups 1408 are adjacent to each other in each odd row, and subpixel groups 1410 and subpixel groups 1412 are adjacent to each other in each even row. Similarly, the human vision system would consider the two separate green vertical lines 1402, 1404 as two straight lines when viewed from a distance. It is understood although only green vertical line(s) are displayed in the examples of FIGS. 12-14, red vertical line(s) can also be displayed in the same manner as shown in the examples of FIGS. 12-14 by turning on half and/or all of the red subpixels in the corresponding subpixel groups.

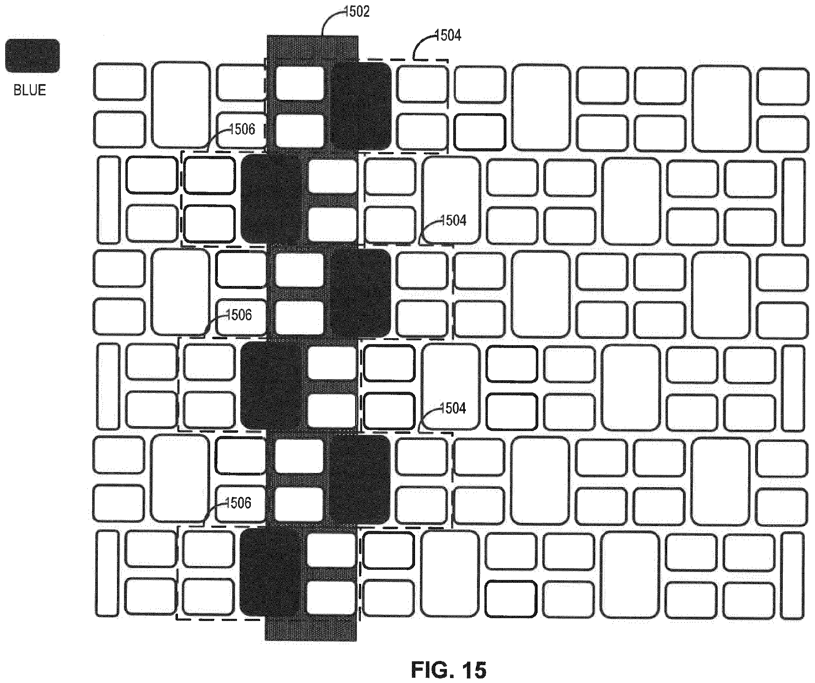

In FIG. 15, a single blue vertical line 1502 is displayed by fully turning on the blue subpixels (i.e., the value of the blue subpixel is 255) in the corresponding subpixel groups 1504, 1506. For example, in each odd row of subpixels, the blue subpixels in the corresponding subpixel groups 1504 are turned on; in each even row of subpixels, the blue subpixels in the corresponding subpixel groups 1506 are turned on. It is understood that because of the staggered arrangement between adjacent rows, the blue subpixels in adjacent rows are not strictly aligned in the vertical direction and thus, the single blue vertical line 1502 in this example is not a straight line. However, the human vision system would consider the single blue vertical line 1502 as a straight line when viewed from a distance.

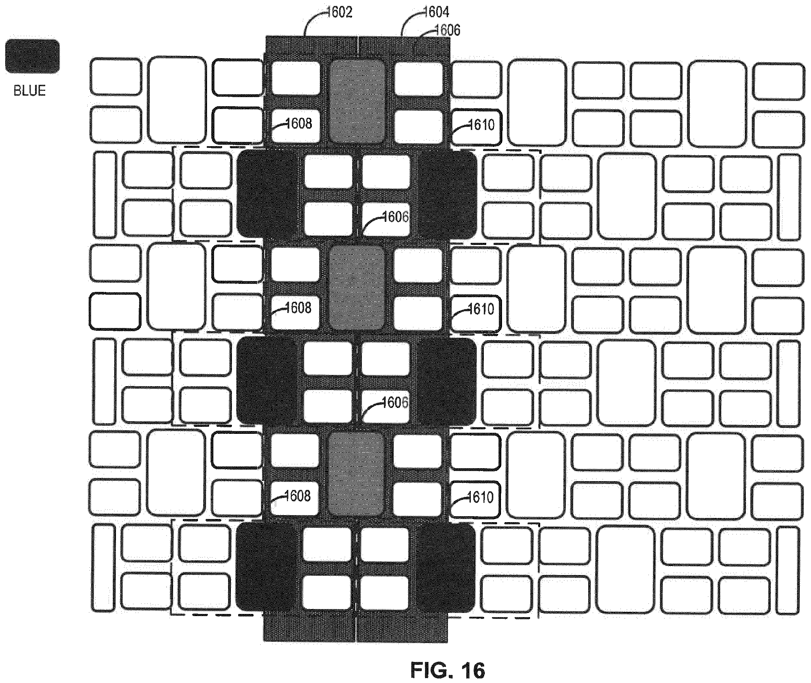

In FIG. 16, two adjacent blue vertical lines 1602, 1604 are displayed by fully or partially turning on the blue subpixels in the corresponding subpixel groups 1606, 1608, 1610. In each odd row, the blue subpixels in the corresponding subpixel groups 1606 are partially turned on (i.e., the value of the blue subpixel is larger than 0 and smaller than 255). In each even row of subpixels, the blue subpixels in the two adjacent subpixel groups 1608, 1610 are fully turned on (i.e., the value of the blue subpixel is 255). Similarly, the human vision system would consider the two adjacent blue vertical lines 1602, 1604 as two straight lines when viewed from a distance.

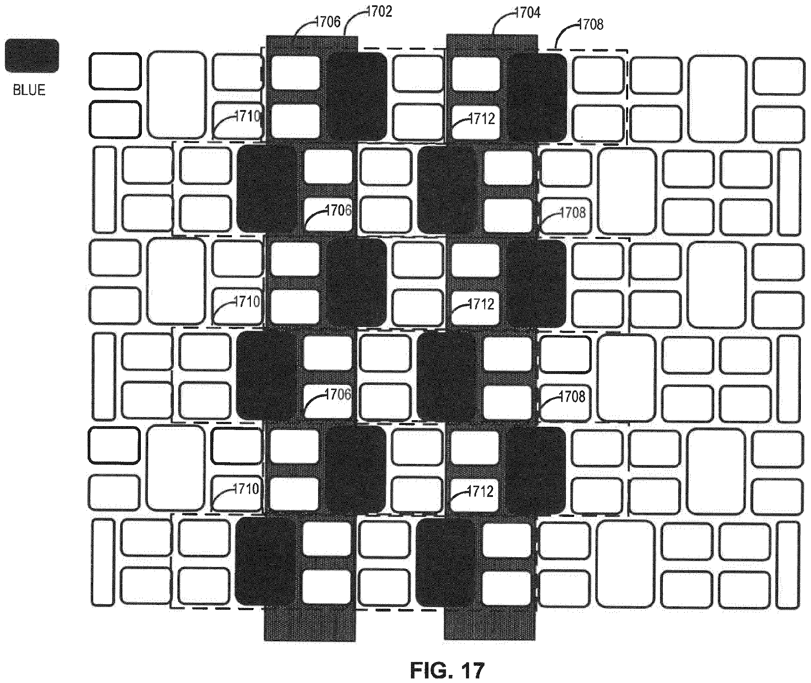

In FIG. 17, two separate blue vertical lines 1702, 1704 are displayed by fully turning on the blue subpixels (i.e., the value of the blue subpixel is 255) in the corresponding subpixel groups 1706, 1708, 1710, 1712. In each odd row of subpixels, the blue subpixels in the two adjacent subpixel groups 1706, 1708 are turned on; in each even row of subpixels, the blue subpixels in the two adjacent subpixel groups 1710, 1712 are turned on. Similarly, the human vision system would consider the two separate blue vertical lines 1702, 1704 as two straight lines when viewed from a distance.

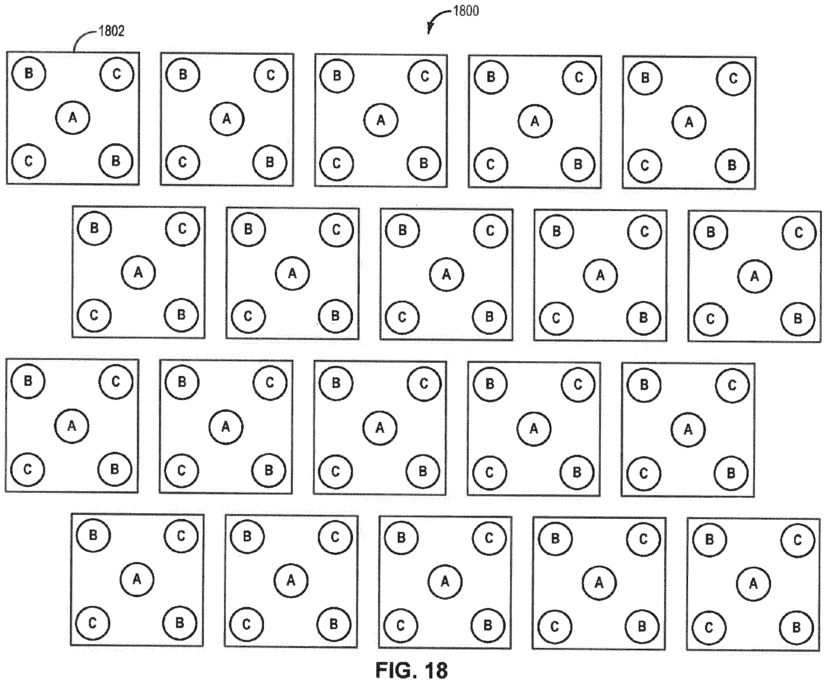

FIG. 18 depicts a subpixel arrangement of an LED lamp display in accordance with one embodiment set forth in the disclosure. FIG. 18 may be, for example, a plan view of the display 102 and depicts one example of the subpixel arrangements of the display 102. The display 102 in this example is an LED lamp display, such as a billboard display with an array 1800 of LED lamps 1802. Each LED lamp 1802 may be considered as a subpixel group, which repeats itself horizontally in each row of the array 1800. Similar to the arrangement of subpixel groups 302 in FIG. 3, LED lamps 1802 in each row of the array 1800 are staggered relative to LED lamps 1802 in an adjacent row of the array 1800 by, for example, half of the width of an LED lamp 1802. LED lamps 1802 in interval rows are aligned along the vertical direction. Each LED lamp 1802 in this embodiment is an assembly/packaging of five LEDs which can be individually controlled. Each LED lamp 1802 includes one LED in a first color A, two LEDs in a second color B, and two LEDs in a third color C. A, B, and C in FIG. 18 denote three different colors, such as but not limited to, red, green, blue, yellow, cyan, or magenta. In one example, the first color A is blue, and the second and third colors B, C are green and red. When all the LEDs in an LED lamp 1802 are turned on, the LED lamp 1802 emits the white light.

In this embodiment, the five LEDs A, B, B, C, and C are arranged in the same pattern in each LED lamp 1802. For each LED lamp 1802, the two LEDs in the second color B, are on different sides of the LED in the first color A along the horizontal direction, and the two LEDs in the third color C are on different sides of the LED in the first color A along the horizontal direction as well. In other words, in each LED lamp 1802, one LED B and one LED C are in the left part of the LED lamp 1802, the other LED B and the other LED C are in the right part of the LED lamp 1802, and the LED A is in the middle of the LED lamp 1802.

In this embodiment, in each LED lamp 1802, one LED B is aligned with one LED C along the vertical direction on the left side of the LED A, and the other LED B is aligned with the other LED C along the vertical direction on the right side of the LED A. Different from the example shown in FIG. 3, in this embodiment, one LED B is aligned with one LED C along the horizontal direction, and the other LED B is aligned with the other LED C along the horizontal direction. In other words, the two LEDs in the same colors (i.e., B and B, or C and C) are arranged flush with each other along the diagonal direction, and the two LEDs in the different colors (i.e., B and C) are arranged flush with each other vertically or horizontally.

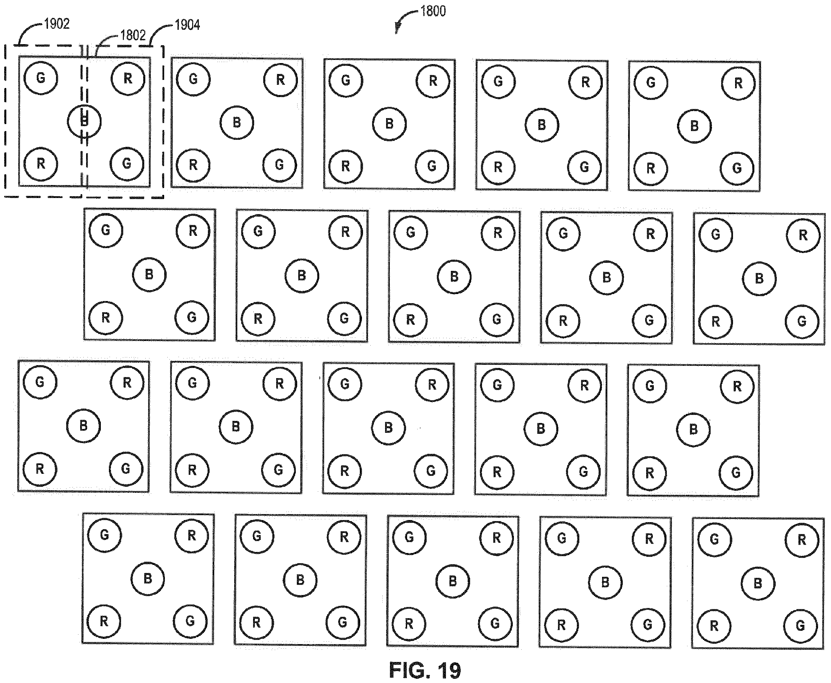

FIG. 19 illustrates one example of pixel division for the subpixel arrangement shown in FIG. 18. In this example, each LED lamp 1802 is divided into two pixels 1902, 1904 such that, each of the two pixels 1902, 1904 includes one of the two LEDs in the second color (e.g., G) and one of the two LEDs in the third color (e.g., R), and that the LED in the first color (e.g., B) is shared by the two pixels 1902, 1904. As shown in FIG. 19, the LED lamp 1802 is evenly divided through the middle of the blue LED into a left part corresponding to one pixel 1902, and a right part corresponding to another pixel 1904. The pixel 1902 includes one green LED, one red LED, and the left part of the blue LED; the pixel 1904 includes one red LED, one green LED, and the right part of the blue LED. That is, each blue LED on the display is shared by two adjacent pixels. It is understood that, in other examples, each LED lamp may include one red LED, two green LEDs, and two blue LEDs, and the red LED is in the middle of the LED lamp and shared by two adjacent pixels.

FIG. 20 depicts one example of a method for subpixel rendering on a display. The method may be implemented by the control logic 104 of the apparatus 100 or on any other suitable machine having at least one processor. The control logic 104 may include logic and module(s) to perform each step of the method described below. The "logic" and "module" referred to herein are defined as any suitable software, hardware, firmware, or any suitable combination thereof that can perform the desired function, such as programmed processors, discrete logic, for example, state machine, to name a few. The method for rendering subpixels may be applied to any one of the subpixel arrangements provided above in FIGS. 3-19 or any other suitable subpixel arrangement in accordance with the present disclosure.

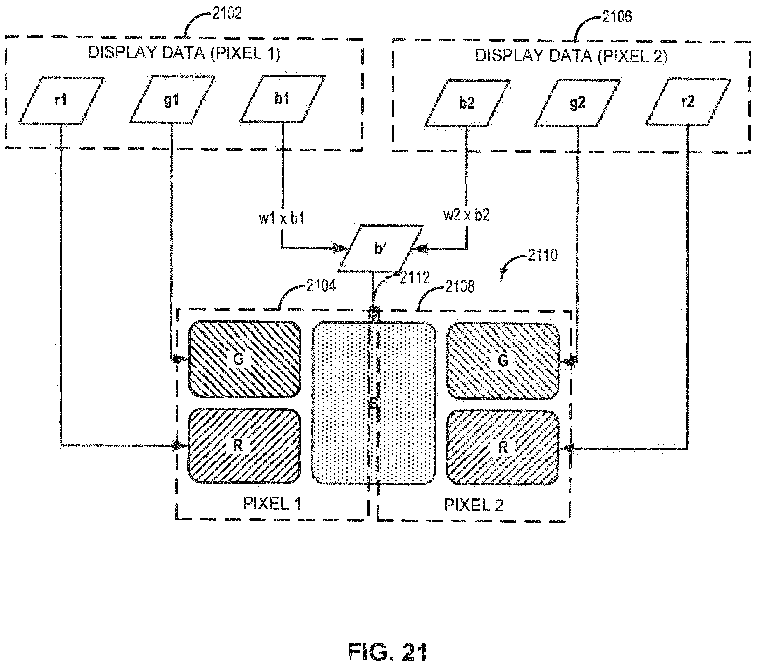

Beginning at 2002, a plurality pieces of display data for displaying a plurality of pixels are received. Each piece of display data includes a first, a second, and a third components representing a first, a second, and a third colors, respectively. In this example, the first color is blue, and the second and third colors are green and red. As noted above, the display data 106 may be programmed at the pixel level and thus and include three components of data for rendering three subpixels with different colors (e.g., three primary colors of red, green, and blue) for each pixel on the display 102. Referring now to FIG. 21, for example, a first piece of display data 2102 for a first pixie 2104 may be represented as (r1, g1, b1). Each of the three components r1, g1, b1 may have a value from 0 to 255. When all the three components are set as 255, the three subpixels in the first pixel 2104 are fully turned on, and the pixel presents the white color; when all the three components are set as 0, the three subpixels in the first pixel 2104 are fully turn off, and the first pixel 2104 presents the black color. Similarly, a second piece of display data 2106 of a second pixel 2108 that is adjacent to the first pixel 2104 in the same row may be represented as (r2, g2, b2). As noted above, the first and second pixels 2104, 2108 are divided from the same subpixel group 2110 and share the blue subpixel B in the subpixel group 2110. Each of the pixels 2104, 2108 further includes a green subpixel G and a red subpixel R.

Referring back to FIG. 20, at 2004, control signals 108 for rendering the array of subpixel groups on the display 102 are provided based on the plurality pieces of display data 106. In one embodiment, at 2006, for each subpixel in the first color, a respective control signal is provided based on first components of two pieces of display data for displaying the two pixels that share the subpixel in the first color. In one example, the respective control signal is obtained by calculating the weighted average of the first components of the two pieces of display data. Referring now to FIG. 21, the control signal 2112 for driving the blue subpixel is obtained by calculating the weighted average of the blue components of the first and second pieces of display data 2102, 2106. For example, the calculation may be performed using the following equations:

$$b'=w1 \times b1 + w2 \times b2 \qquad (1)$$

where $b'$ is the value of the control signal 2112 for the blue subpixel, $b1, b2$ are the values of the blue components of the two pieces of display data 2102, 2106, respectively, and $w1, w2$ are weights of $b1, b2$, respectively. In one example, both $w1$ and $w2$ equal to ½, and $b'$ is the average of $b1$ and $b2$. It is understood that the values of $w1, w2$ may be different in other examples. As to the green and red subpixels, the corresponding components in the corresponding pixels may be used directly to provide the control signals for driving the green and red subpixels. As shown in FIG. 21, g1 is used to provide the control signal for the green subpixel in the first pixel 2104, and r1 is used to provide the control signal for the red subpixel in the first pixel 2104. Similarly, g2 is used to provide the control signal for the green subpixel in the second pixel 2108, and r2 is used to provide the control signal for the red subpixel in the second 2108. It is understood that, in other examples, the first color may be red, and the weighted average of the red components of the first and second pieces of display may be calculated in the same manner as described above.

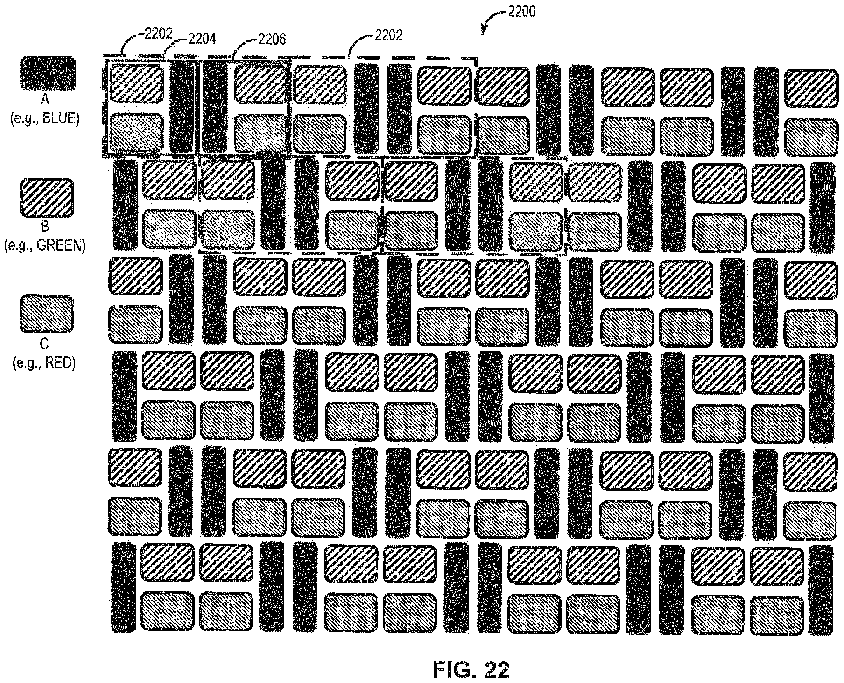

FIG. 22 depicts another example of subpixel arrangement of an OLED display in accordance with one embodiment set forth in the disclosure. FIG. 22 may be, for example, a plan view of the display 102 and depicts one example of the subpixel arrangements of the display 102. The display 102 includes an array 2200 of subpixel groups 2202. Each subpixel group 2202 in this embodiment includes six subpixels: two subpixels in a first color A, two subpixels in a second color B, and two subpixels in a third color C. A, B, and C in FIG. 22 denote three different colors, such as but not limited to, red, green, blue, yellow, cyan, magenta, or white. In one example, the first color A is blue, and the second and third colors B, C are green and red. Subpixel groups 2202 in each row of the array 2200 are repeated along the horizontal direction. Subpixel groups 2202 in each row of the array 2200 are staggered relative to subpixels groups 2202 in an adjacent row of the array 2200. In other words, subpixel groups 2202 in adjacent rows are staggered along the horizontal direction. In this embodiment, subpixel groups 2202 in interval rows are aligned along the vertical direction. That is, subpixel groups 2202 in each odd row are aligned along the vertical direction, and subpixel groups 2202 in each even row are aligned along the vertical direction. Stated in another way, subpixel groups 2202 in each row are arranged repeatedly, and the subpixel groups 2202 in adjacent rows are arranged shifted from each other by, for example, ½ of the repeat pitch.

In another example, the first color A is red, and the second and third colors B, C are green and blue.

In this embodiment, the six subpixels A, A, B, B, C, and C are arranged in the same pattern in each subpixel group 2202. For each subpixel group 2202, the two subpixels in the second color B are on different sides of the two subpixel in the first color A along the horizontal direction, and the two subpixels in the third color C are on different sides of the two subpixels in the first color A along the horizontal direction as well. That is, in the horizontal direction, the two subpixels A are between the two subpixels B, and also between the two subpixels C. In other words, in each subpixel group 2202, one subpixel B and one subpixel C are in the left part of the subpixel group 2202, the other subpixel B and the other subpixel C are in the right part of the subpixel group 2202, and the two subpixels A are in the middle of the subpixel group 2202. In each subpixel group 2202, the two subpixels B have the same size and shape, and the two subpixels C have the same size and shape as well.

In this embodiment, in each subpixel group 2202, one subpixel B is aligned with one subpixel C along the vertical direction on the left side of the two subpixels A, and the other subpixel B is aligned with the other subpixel C along the vertical direction on the right side of the two subpixels A. The two subpixels B are aligned with each other along the horizontal direction, and the two subpixels C are aligned with each other along the horizontal direction as well. In other words, the two subpixels in the same colors (i.e., B and B, or C and C) are arranged flush with each other horizontally, and the two subpixels in the different colors (i.e., B and C) are arranged flush with each other vertically. It is understood that even if two subpixels have different sizes and/or shapes, they are considered as being "aligned" if the centers of the two subpixels are aligned vertically or horizontally.

In this embodiment, each subpixel group 2202 is divided into two pixels 2204, 2206 such that each of the two pixels 2204, 2206 includes one of the two subpixels in the first color A, one of the two subpixels in the second color B, and one of the two subpixels in the third color C. As shown in FIG. 22, the subpixel group 2202 is evenly divided into a left part corresponding to one pixel 2204 and a right part corresponding to another pixel 2206.

In this embodiment, each subpixel corresponds to an OLED, and for each subpixel group 2202, the two OLEDs in the first color (e.g., blue or red) have the same shape and size and share the same organic light-emitting layer in the similar manner as discussed above with respect to FIG. 5. Each of the OLEDs in this embodiment has a substantially rectangular shape. However, it is understood that the shape of each subpixel in other examples may vary. Other shapes of the subpixels include, but are not limited to, substantially round, triangle, square, pentagon, hexagon, heptagon, octagon, or any other suitable shape. It is understood that the subpixels are not limited to OLEDs and may be, for example, LEDs of a billboard display with LED lamps or any other suitable display devices as known in the art.

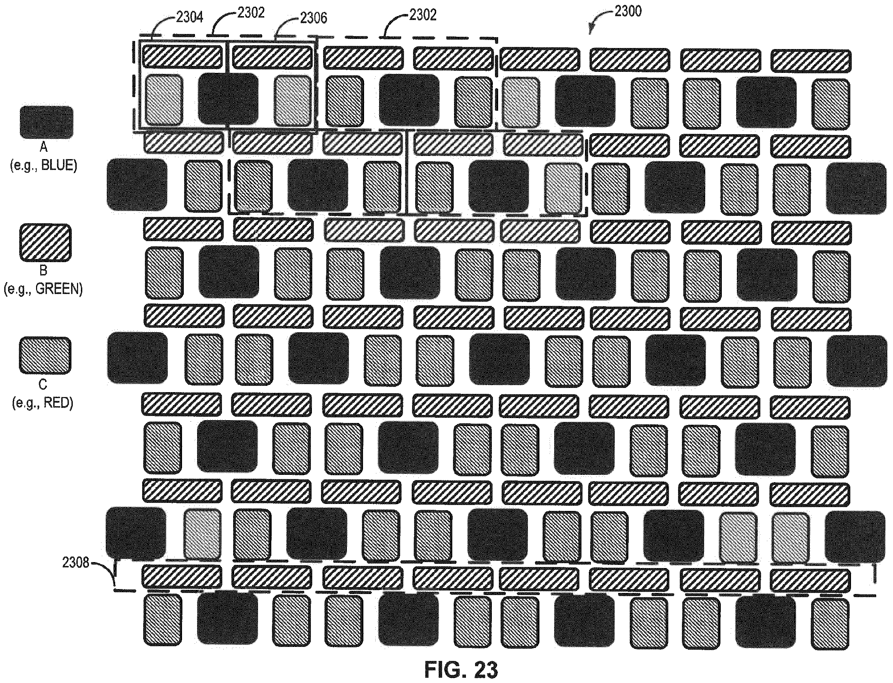

FIG. 23 depicts still another example of subpixel arrangement of an OLED display in accordance with one embodiment set forth in the disclosure. FIG. 23 may be, for example, a plan view of the display 102 and depicts one example of the subpixel arrangements of the display 102. The display 102 includes an array 2300 of subpixel groups 2302. Each subpixel group 2302 in this embodiment includes five subpixels: one subpixel in a first color A, two subpixels in a second color B, and two subpixels in a third color C. A, B, and C in FIG. 23 denote three different colors, such as but not limited to, red, green, blue, yellow, cyan, magenta, or white. In one example, the first color A is blue, and the second and third colors B, C are green and red. Subpixel groups 2302 in each row of the array 2300 are repeated along the horizontal direction. Subpixel groups 2302 in each row of the array 2300 are staggered relative to subpixels groups 2302 in an adjacent row of the array 2300. In other words, subpixel groups 2302 in adjacent rows are staggered along the horizontal direction. In this embodiment, subpixel groups 2302 in interval rows are aligned along the vertical direction. That is, subpixel groups 2302 in each odd row are aligned along the vertical direction, and subpixel groups 2302 in each even row are aligned along the vertical direction. Stated in another way, subpixel groups 2302 in each row are arranged repeatedly, and the subpixel groups 2302 in adjacent rows are arranged shifted from each other by, for example, ½ of the repeat pitch. In another example, the first color A is red, and the second and third colors B, C are green and blue.

In this embodiment, the five subpixels A, B, B, C, and C are arranged in the same pattern in each subpixel group 2302. For each subpixel group 2302, the two subpixels in the second color B are on the same side of the subpixel in the first color A along the vertical direction. In other words, the two subpixels B are above the subpixel A in each subpixel group 2302. The two subpixels in the third color C are on different sides of the subpixel in the first color A along the horizontal direction. That is, in the horizontal direction, the subpixel A is between the two subpixels C. In each subpixel group 2302, the two subpixels B have the same size and shape, and the two subpixels C have the same size and shape as well. However, in this embodiment, the size and shape of the subpixel B may be different from the size and shape of the subpixel C.

In this embodiment, in each subpixel group 2302, the two subpixels B are aligned with each other along the horizontal direction, and the two subpixels C are aligned with each other along the horizontal direction as well. In other words, the two subpixels in the same colors (i.e., B and B, or C and C) are arranged flush with each other horizontally. It is understood that even if two subpixels have different sizes and/or shapes, they are considered as being "aligned" if the centers of the two subpixels are aligned vertically or horizontally.

In this embodiment, each subpixel group 2302 is divided into two pixels 2304, 2306 such that each of the two pixels 2304, 2306 includes one of the two subpixels in the second color B, one of the two subpixels in the third color C, and shares the subpixel in the first color A. As shown in FIG. 23, the subpixel group 2302 is evenly divided into a left part corresponding to one pixel 2304 and a right part corresponding to another pixel 2306.

In this embodiment, each subpixel corresponds to an OLED, and in each subpixel group 2302, the OLED in the third color C shares the same organic light-emitting layer with a respective OLED in the third color C in the adjacent subpixel group 2302 in the same row of the array 2300. In this embodiment, in each subpixel group 2302, the two OLEDs in the second color B share the same organic light-emitting layer in the similar manner as discussed above with respect to FIG. 5. In each subpixel group 2302, the OLED in the second color B also shares the same organic light-emitting layer with a respective OLED in the second color B in the adjacent subpixel group 2302 in the same row of the array 2300. That is, in this embodiment, all OLEDs in the second color B in the same row of the array 2300 share the same organic light-emitting layer 2308, which is fabricated through a "slit" opening on the evaporation mask.

Each of the OLEDs in this embodiment has a substantially rectangular shape. However, it is understood that the shape of each subpixel in other examples may vary. Other shapes of the subpixels include, but are not limited to, substantially round, triangle, square, pentagon, hexagon, heptagon, octagon, or any other suitable shape. It is understood that the subpixels are not limited to OLEDs and may be, for example, LEDs of a billboard display with LED lamps or any other suitable display devices as known in the art.

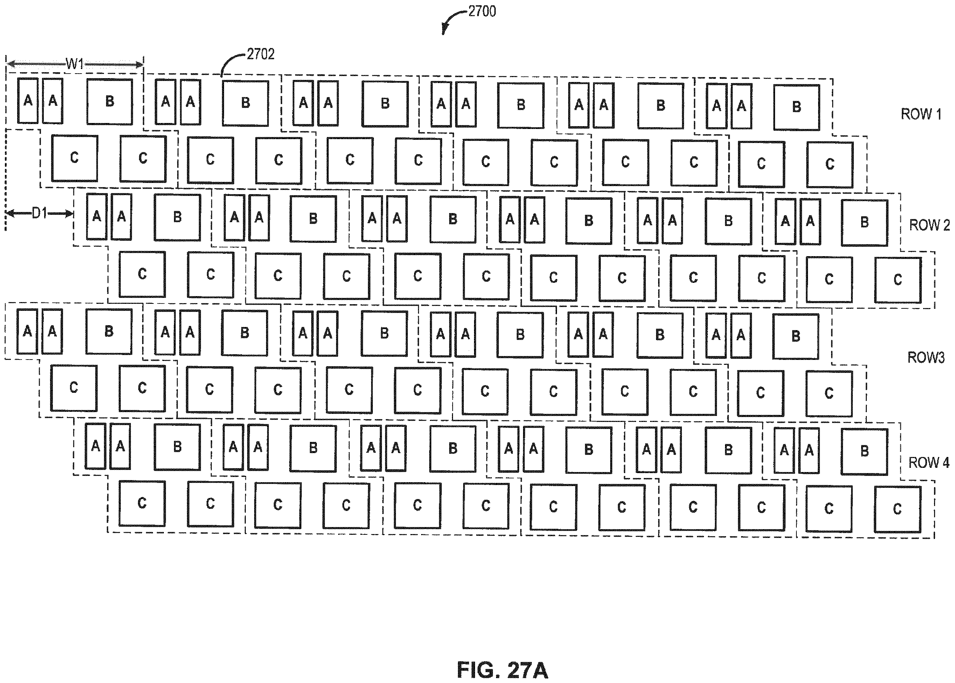

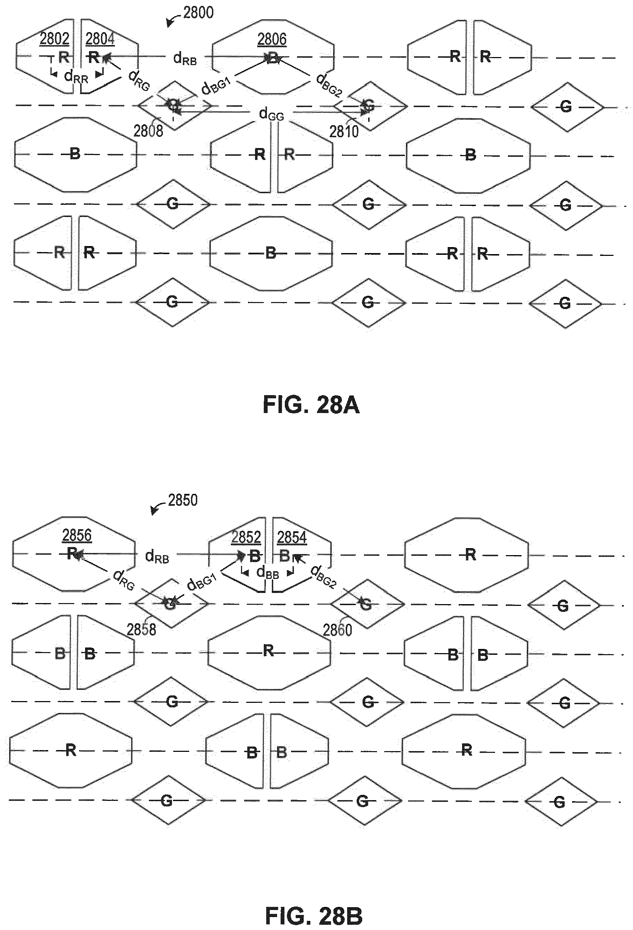

FIGs. 27A-27C each depicts another subpixel arrangement of a display in accordance with some embodiments in the disclosure. FIGs. 27A-27C may each be, for example, a plan view of the display 102 and depicts one example of subpixel arrangements of the display 102. In FIGs. 27A-27C, for ease of illustration, the subpixels are depicted as rectangles to show the relative positions of subpixels in each subpixel group and in array 2700. The actual shape and size of each subpixel are described in FIGs. 28-31.

As shown in FIG. 27A, display 102 may include an array 2700 that includes at least one subpixel group 2702. In some embodiments, array 2700 is arranged in rows or columns. Subpixel group 2702 in this embodiment includes five subpixels: two subpixels in a first color A, one subpixel in a second color B, and two subpixels in a third color C. A, B, and C in FIG. 27A denote three different colors, such as but not limited to, red, green, blue, yellow, cyan, magenta, or white. In some embodiments, A is red, B is blue, and C is green. In some embodiments, array 2700 includes a plurality of subpixel groups 2702 repeated along the row direction (e.g., the horizontal direction), forming one or more rows (e.g., Row 1, Row 2, Row 3, Row 4, etc.). In some embodiments, a plurality of rows of repeated subpixel groups 2702 are formed. In various embodiments, subpixel groups 2702 may form a portion of or the entire array 2700. Subpixel groups 2702 in each row of array 2700 are staggered relative to subpixels groups 2702 in an adjacent row of array 2700. In other words, subpixel groups 2702 in adjacent rows are staggered along the horizontal direction. For example, as shown in FIG. 27A, subpixel groups 2702 in Row 1 are staggered relative to subpixel groups 2702 in Row 2 by a distance of $D1$. It is understood that the distance $D1$ is less than the width $W1$ of the subpixel group 302. In one example, the distance $D1$ equals ½ of the width $W1$ of the subpixel group 2702. In this embodiment, subpixel groups 2702 in interval rows are aligned along the vertical direction. That is, subpixel groups 2702 in each odd row (e.g., Row 1, Row 3, etc.) are aligned along the vertical direction, and subpixel groups 2702 in each even row (e.g., Row 2, Row 4, etc.) are aligned along the vertical direction. Stated in another way, subpixel groups 2702 in each row are arranged repeatedly, and the subpixel groups 2702 in adjacent rows are arranged shifted from each other by, for example, ½ of the repeat pitch.

In this embodiment, the five subpixels in colors A, A, B, C, and C are arranged in the same pattern in each subpixel group 2702. For each subpixel group 2702, the two subpixels in the first color A may be aligned with each other along the horizontal direction, and may be further aligned with the subpixel in the second color B along the horizontal direction. The two subpixels in the first color A may be positioned on the left part in subpixel group 2702 and the subpixel in the second color B may be positioned on the right part in subpixel group 2702. The two subpixels in the third color C may be aligned with each other along the horizontal direction, and may be positioned below the subpixels in first and second colors A and B. That is, the two subpixels in the first color A and the subpixel in the second color B may be above the two subpixels in the third color C. In other words, as shown in FIG. 27A, the two subpixels in the first color A and the subpixel in the second color B may be positioned in the upper part in subpixel group 2702, and the two subpixels in the third color C may be in the lower part in subpixel group 2702.

In this embodiment, in each subpixel group 2702, along the vertical direction, one subpixel in the third color C (e.g., the subpixel in the third color C on the left part of subpixel group 2702) is aligned with the middle point of subpixels in colors A and B. For ease of description, the middle point of subpixels in colors A and B is defined as the point that has an equal horizontal distance to the center (or geometric center) of the subpixel in the second color B and the center of the two subpixels in the first color A. The center of the two subpixels in the first color A is defined as the geometric center of the two subpixels in the first color A. In some embodiments, the other subpixel in the third color C (e.g., the subpixel in the third color C on the right part of subpixel group 2702) is aligned with the middle point of the subpixel in the second B of the same subpixel group and the subpixels in the first colors A in an adjacent subpixel group (e.g., the subpixel group on the right). That is, in each row (e.g., ROW 1, ROW 2, ..., etc.), each subpixel in the third color C is aligned with the middle point of the adjacent subpixel in the second color B and the adjacent subpixels in the first color A. In some embodiments, a distance between the subpixel in the third color C (e.g., the center or the geometric center of the subpixel) and the adjacent subpixel in the second color B (e.g., the center or the geometric center of the subpixel) is equal to (or nominally equal to) a distance between the subpixel in the third color C and the adjacent subpixels in the first color A (e.g., the center of the geometric center of the two subpixels). It is understood that even if two subpixels have different sizes and/or shapes, they are considered as being "aligned" if the centers of the two subpixels are aligned vertically or horizontally.

As described earlier, array 2700 may include at least one subpixel group 2702 distributed in any suitable arrangement. In various embodiments, the at least one subpixel group 2702 may form one or more rows (e.g., ROW 1, ROW 2, ..., etc.) in array 2700, while each row may constitute a portion of or the entirety of a row of array 2700. The rows that include the at least one subpixel group 2702 may be repeated continuously along the vertical direction, e.g., as the example shown in FIG. 27A, or may be distributed intermittently. For example, the rows may be the upper or lower half of array 2700, may be distributed only in the odd or even rows of array 2700, or may be distributed to constitute the entire array 2700. The specific arrangement of the at least one subpixel group 2702 should not be limited by the embodiments of the present disclosure.

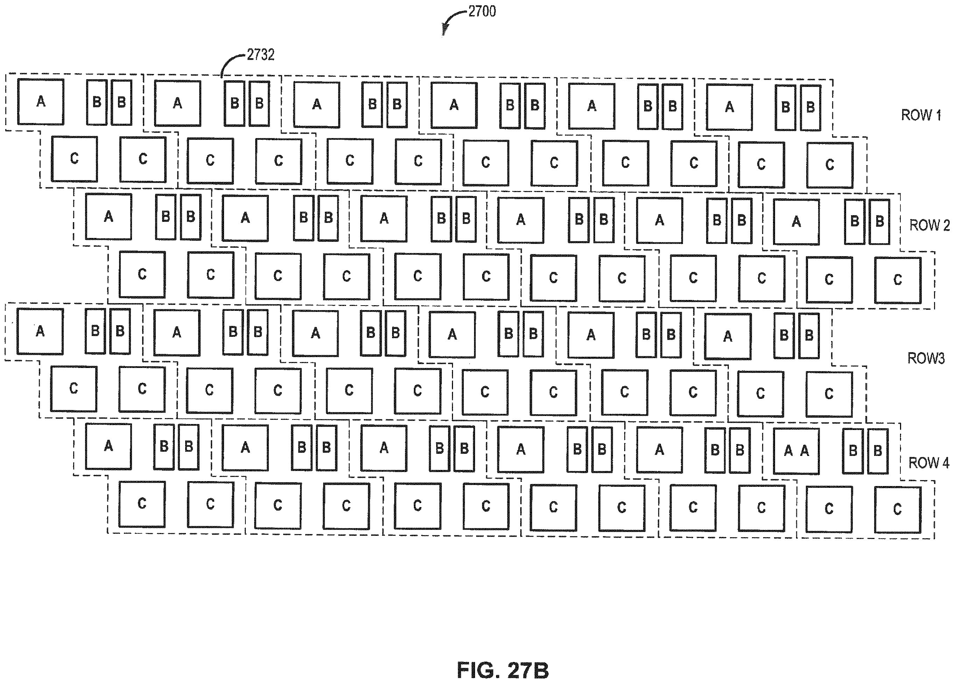

FIG. 27B illustrates another subpixel arrangement of the display, according to some embodiments. Array 2700 may include at least one subpixel group 2732. Subpixel group 2732 in this embodiment includes five subpixels: two subpixels in a first color B, one subpixel in a second color A, and two subpixels in a third color C. A, B, and C in FIG. 27B denote three different colors, such as but not limited to, red, green, blue, yellow, cyan, magenta, or white. In some embodiments, A is red, B is blue, and C is green. In some embodiments, array 2700 includes a plurality of subpixel groups 2732 repeated along the row direction (e.g., the horizontal direction), forming one or more rows (e.g., Row 1, Row 2, Row 3, Row 4, etc.). In some embodiments, a plurality of rows of repeated subpixel groups 2732 are formed. In various embodiments, subpixel groups 2732 may form a portion of or the entire array 2700. Similar to subpixel groups 2702, subpixel groups 2732 in each row of array 2700 are staggered relative to subpixels groups 2732 in an adjacent row of array 2700. The arrangement of subpixel groups 2732 along the horizontal direction and the vertical direction may be similar to those of subpixel groups 2702, and the description is not repeated herein.

In this embodiment, the five subpixels in colors A, B, B, C, and C are arranged in the same pattern in each subpixel group 2732. For each subpixel group 2732, the two subpixels in the first color B may be aligned with each other along the horizontal direction, and may be further aligned with the subpixel in the second color A along the horizontal direction. The two subpixels in the first color B may be positioned on the right part in subpixel group 2732 and the subpixel in the second color A may be positioned on the left part in subpixel group 2732. The two subpixels in the third color C may be aligned with each other along the horizontal direction, and may be positioned below the subpixels in first and second colors A and B. That is, the two subpixels in the first color B and the subpixel in the second color A may be above the two subpixels in the third color C. In other words, as shown in FIG. 27B, the two subpixels in the first color B and the subpixel in the second color A may be positioned in the upper part in subpixel group 2732, and the two subpixels in the third color C may be in the lower part in subpixel group 2732.

In this embodiment, in each subpixel group 2732, along the vertical direction, one subpixel in the third color C (e.g., the subpixel in the third color C on the left part of subpixel group 2732) is aligned with the middle point of subpixels in colors A and B. For ease of description, the middle point of subpixels in colors A and B is defined as the point that has an equal horizontal distance to the center (or geometric center) of the subpixel in the second color A and the center of the two subpixels in the first color B. The center of the two subpixels in the first color B is defined as the geometric center of the two subpixels in the first color B. In some embodiments, the other subpixel in the third color C (e.g., the subpixel in the third color C on the right part of subpixel group 2732) is aligned with the middle point of the subpixel in the second color A of the same subpixel group and the subpixels in the first colors B in an adjacent subpixel group (e.g., the subpixel group on the right). That is, in each row (e.g., ROW 1, ROW 2, ..., etc.), each subpixel in the third color C is aligned with the middle point of the adjacent subpixel in the second color A and the adjacent subpixels in the first color B. In some embodiments, a distance between the subpixel in the third color C (e.g., the center or the geometric center of the subpixel) and the adjacent subpixel in the second color A (e.g., the center or the geometric center of the subpixel) is equal to (or nominally equal to) a distance between the subpixel in the third color C and the adjacent subpixels in the first color B (e.g., the center of the geometric center of the two subpixels).

Similar to the arrangement of subpixel groups 2702, array 2700 may include at least one subpixel group 2732 distributed in any suitable arrangement. In various embodiments, the at least one subpixel group 2732 may form one or more rows (e.g., ROW 1, ROW 2, ..., etc.) in array 2700, while each row may constitute a portion of or the entirety of a row of array 2700. The rows that include the at least one subpixel group 2732 may be repeated continuously along the vertical direction, e.g., as the example shown in FIG. 27B, or may be distributed intermittently. For example, the rows may be the upper or lower half of array 2700, may be distributed only in the odd or even rows of array 2700, or may be distributed to constitute the entire array 2700. The specific arrangement of the at least one subpixel group 2732 should not be limited by the embodiments of the present disclosure.

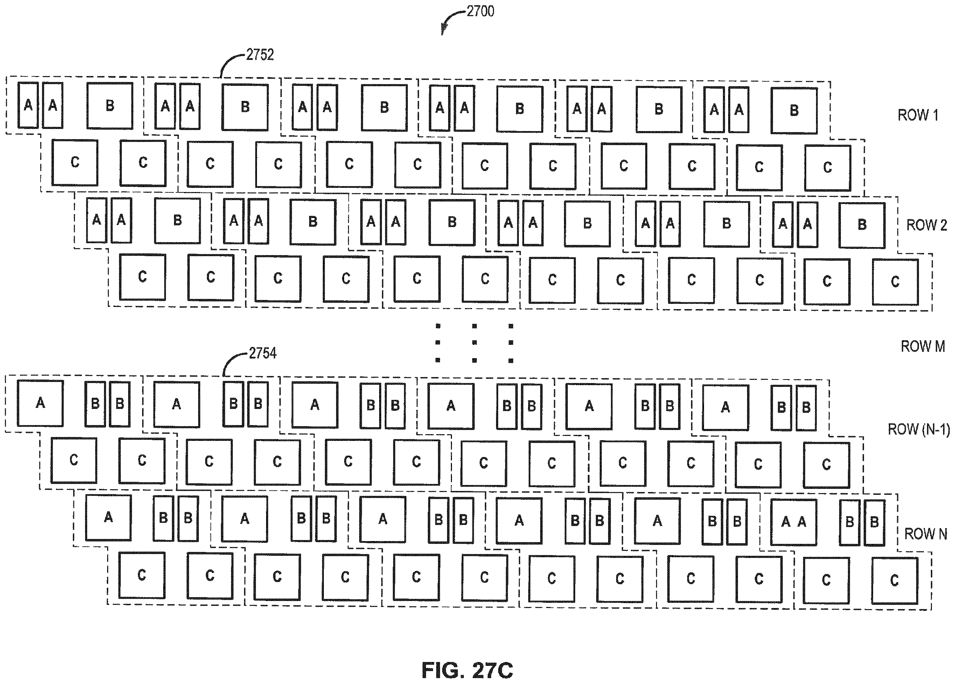

FIG. 27C illustrates another subpixel arrangement of the display, according to some embodiments. As shown in FIG. 27C, array 2700 may include at least one first subpixel group 2752 and at least one second subpixel group 2754. First subpixel group 2752 may be different from second subpixel group 2754. As an example, first subpixel group 2752 is the same as subpixel group 2702, and second subpixel group 2754 is the same as subpixel group 2754. In some embodiments, array 2700 may include other subpixel groups that are different from first and second subpixel groups 2752 and 2754. As shown in FIG. 27C, first and second subpixel groups 2752 and 2754 may each have any suitable arrangement in array 2700. In some embodiments, first subpixel groups 2752 are repeated along the horizontal direction and form M rows (e.g., ROW 1, ROW 2, ..., ROW M), each row being staggered from the adjacent rows, similar to the arrangement of subpixel groups 2702 and 2732. Second subpixel groups 2754 are repeated along the horizontal direction and form (N-M) rows (e.g., ROW (M+1), ROW (M+2), ..., ROW N), each row being staggered from the adjacent rows, similar to the arrangement of subpixel groups 2702 and 2732. M and N are each positive integers and M is less than N. In some embodiments, first subpixel groups 2752 form the upper half of array 2700, and second subpixel groups 2754 form the lower half of array 2700. In some embodiments, first subpixel groups 2752 form odd rows (e.g., ROW 1, ROW 3, ..., etc.) and second subpixel groups 2754 form even rows (e.g., ROW 2, ROW 4, ..., etc.), and vice versa.

In some embodiments, array 2700 includes third subpixel groups different from first and second subpixel groups 2752 and 2754. The third subpixel groups may separate one or more first subpixel groups 2752 (or second subpixel groups 2754) from other first or second subpixel groups. For example, first subpixel groups 2752 and/or second subpixel groups 2754 may each be arranged intermittently with the third subpixel groups in a row. In another example, a row of the third subpixel groups may separate a row of first subpixel groups 2752 (and/or second subpixel groups) from another row of first subpixel groups 2752 (and/or second subpixel groups). That is, the at least one first subpixel group 2752 and the at least one second subpixel group 2754 may have any suitable arrangement, alone or with other different subpixel groups, and the arrangement should not be limited by the embodiments of the present disclosure.

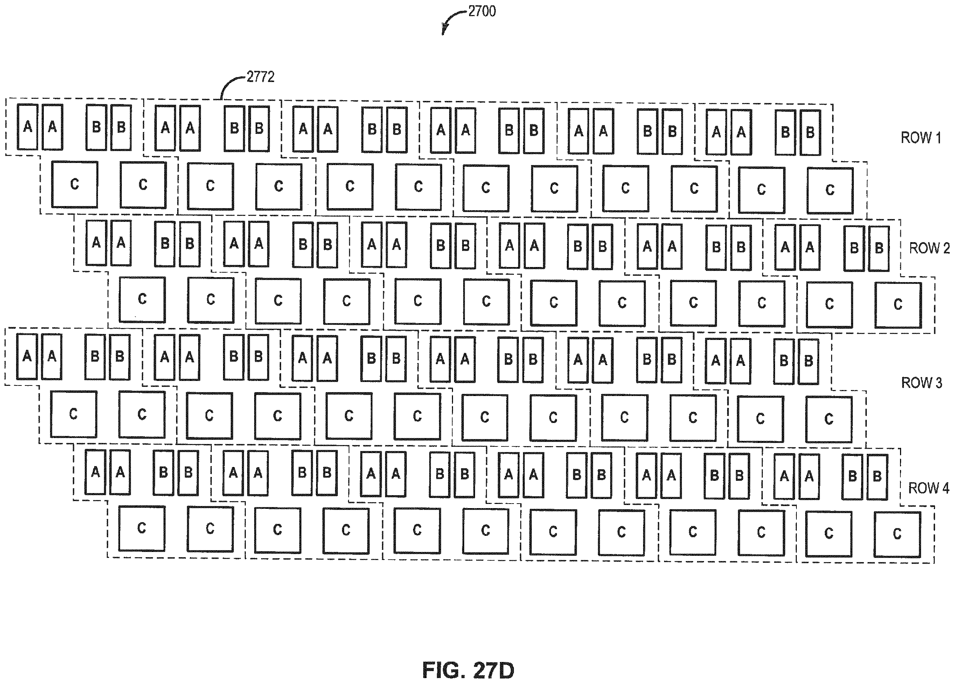

FIG. 27D illustrates another subpixel arrangement of the display, according to some embodiments.

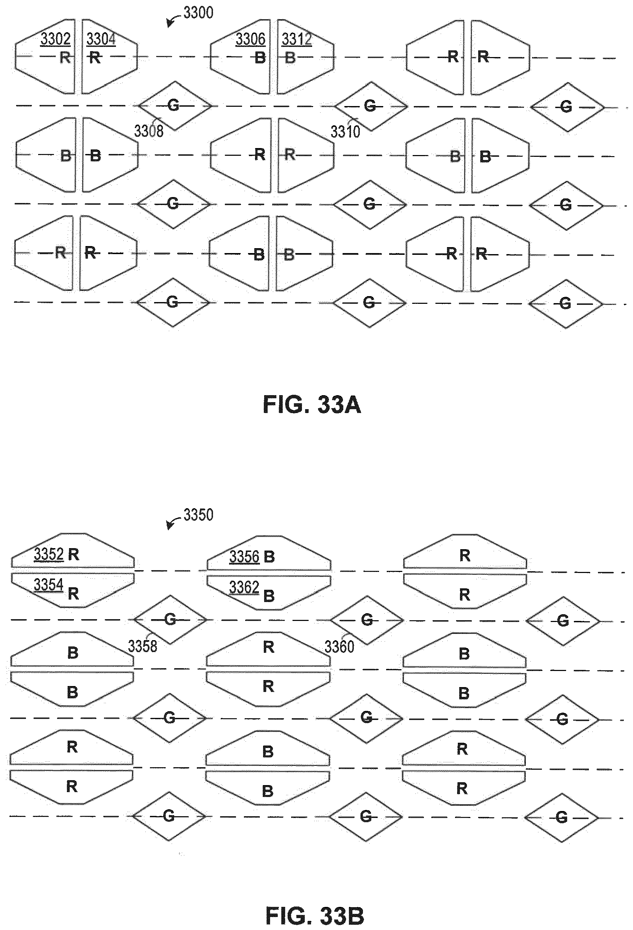

Array 2700 may include at least one subpixel group 2772. Subpixel group 2772 in this embodiment includes six subpixels: two subpixels in a first color A, two subpixels in a second color B, and two subpixels in a third color C. A, B, and C in FIG. 27D denote three different colors, such as but not limited to, red, green, blue, yellow, cyan, magenta, or white. In some embodiments, A is red, B is blue, and C is green. In some embodiments, array 2700 includes a plurality of subpixel groups 2772 repeated along the row direction (e.g., the horizontal direction), forming one or more rows (e.g., Row 1, Row 2, Row 3, Row 4, etc.). In some embodiments, a plurality of rows of repeated subpixel groups 2772 are formed. In various embodiments, subpixel groups 2772 may form a portion of or the entire array 2700. Similar to subpixel groups 2702, subpixel groups 2772 in each row of array 2700 are staggered relative to subpixels groups 2772 in an adjacent row of array 2700. The arrangement of subpixel groups 2772 along the horizontal direction and the vertical direction may be similar to those of subpixel groups 2702, and the description is not repeated herein. The actual shapes, sizes, and arrangement of the subpixels in subpixel group 2772 are described in FIGs. 33A and 33B.

In this embodiment, the six subpixels in colors A, A, B, B, C, and C are arranged in the same pattern in each subpixel group 2772. For each subpixel group 2772, the two subpixels in the first color A may be aligned with each other along the horizontal direction, and the two subpixels in the second color B may be aligned with each other along the horizontal direction. In some embodiments, the four subpixels in the first and second colors A and B are aligned with one another along the horizontal direction. The two subpixels in the first color A may be positioned on the left part in subpixel group 2772 and the two subpixels in the second color B may be positioned on the right part in subpixel group 2772. The two subpixels in the third color C may be aligned with each other along the horizontal direction, and may be positioned below the subpixels in first and second colors A and B. That is, the two subpixels in the first color A and the two subpixels in the second color B may be above the two subpixels in the third color C. In other words, as shown in FIG. 27D, the two subpixels in the first color A and the two subpixels in the second color B may be positioned in the upper part in subpixel group 2772, and the two subpixels in the third color C may be in the lower part in subpixel group 2772.

In this embodiment, in each subpixel group 2772, along the vertical direction, one subpixel in the third color C (e.g., the subpixel in the third color C on the left part of subpixel group 2772) is aligned with the middle point of subpixels in colors A and B. For ease of description, the middle point of subpixels in colors A and B is defined as the point that has an equal horizontal distance to the center (or geometric center) of the two subpixels in the first color A and the center of the two subpixels in the second color B. In some embodiments, the other subpixel in the third color C (e.g., the subpixel in the third color C on the right part of subpixel group 2772) is aligned with the middle point of the two subpixels in the second color B of the same subpixel group and the two subpixels in the first colors A in an adjacent subpixel group (e.g., the subpixel group on the right). That is, in each row (e.g., ROW 1, ROW 2, ..., etc.), each subpixel in the third color C is aligned with the middle point of the adjacent subpixels in the first color A and the adjacent subpixels in the second color B. In some embodiments, a distance between the subpixel in the third color C and the adjacent subpixels in the first color A is equal to (or nominally equal to) a distance between the subpixel in the third color C and the adjacent subpixels in the second color B.

Similar to the arrangement of subpixel groups 2702, array 2700 may include at least one subpixel group 2772 distributed in any suitable arrangement. In various embodiments, the at least one subpixel group 2772 may form one or more rows (e.g., ROW 1, ROW 2, ..., etc.) in array 2700, while each row may constitute a portion of or the entirety of a row of array 2700. The rows that include the at least one subpixel group 2772 may be repeated continuously along the vertical direction, e.g., as the example shown in FIG. 27D, or may be distributed intermittently. For example, the rows may be the upper or lower half of array 2700, may be distributed only in the odd or even rows of array 2700, or may be distributed to constitute the entire array 2700. The specific arrangement of the at least one subpixel group 2772 should not be limited by the embodiments of the present disclosure.

FIGs. 28A, 28B, 29A, 29B, 30A, 30B, 31A, and 32B each depicts a red, green, and blue subpixel arrangement of an OLED display in accordance with some embodiments. Specifically, FIGs. 28A, 29A, 30A, and 31A each illustrate the subpixel arrangement of a subpixel group that has two red subpixels, one blue subpixel, and two green subpixels, and FIGs. 28B, 29B, 30B, and 31B each illustrate the subpixel arrangement of a subpixel group that has two blue subpixels, one red subpixel, and two green subpixels. Each of these figures may be, for example, a plan view of the display 102 and depicts one example of subpixel arrangements of the display 102. In this embodiment, each subpixel corresponds to an OLED.

As shown in FIG. 28A, each subpixel group 2800 includes two red ("R") OLEDs 2802 and 2804, one blue ("B") OLED 2806, and two green ("G") OLEDs 2808 and 2810. In this embodiment, subpixel groups 2800 are repeated horizontally in the same row and are staggered relative to subpixel groups 2800 in the adjacent row by half of the width of subpixel group 2800. In each subpixel group 2800, two red OLEDs 2802 and 2804 are positioned at the upper left side, blue OLED B 2806 is positioned at the upper right side, green OLED 2808 is positioned at the lower left side, and green OLED 2810 is positioned at the lower right side. In some embodiments, green OLED 2808 aligned with the middle point of two red OLEDs 2802 and 2804 and blue OLED 2806 along the vertical direction, and green OLED 2810 is aligned with the middle point of blue OLED 2806 and the two red OLEDs in the adjacent pixel group 2800 on the right.

In this embodiment, in each subpixel group 2800, the total area of two red OLEDs 2802 and 2804 is greater than the area of each green OLED 2808/2810. In some embodiments, the area of blue OLED 2806 is greater than the area of each green OLED 2808/2810. In some embodiments, the area and size of green OLEDs 2808 and 2810 are the same (or nominally the same). In some embodiments, the total area of two red OLEDs 2802 and 2804 is the same as (or nominally the same as) the area of blue OLED 2806. In some embodiments, each of the OLEDs in subpixel group 2800 has a polygonal shape. For example, as shown in FIG. 28A, red OLEDs 2802 and 2804 may each have a hexagonal shape, blue OLED 2806 may have an octagonal shape, and green OLED 2808 and 2810 may have the same rhombus shape. However, it is understood that the shape of each subpixel in other examples may vary. Other shapes of the OLEDs include, but are not limited to, substantially round, triangle, square, pentagon, heptagon, or any other suitable shape. The regions between the OLEDs may be filled with the black matrix as noted above.

In some embodiments, in subpixel group 2800, a distance $d_{RR}$ between two red OLEDs 2802 and 2804 is less than a minimum distance between any two of the OLEDs of different colors. For example, $d_{RR}$ may respectively be less than a distance $d_{RB}$ between red OLED 2804 and blue OLED 2806, a distance $d_{RG}$ between red OLED 2804 and green OLED 2808, a distance $d_{BG1}$ between green OLED 2808 and blue OLED 2806, and a distance $d_{BG2}$ between green OLED 2810 and blue OLED 2806. In some embodiments, distance $d_{BG1}$ is equal to distance $d_{BG2}$. It should be understood that because red OLED 2802 is on the left side of red OLED 2804, the distance between red OLED 2802 to any other OLEDs of a different color is greater than the distance between red OLED 2804 to these other OLEDs, distance $d_{RR}$ is thus less than the distance between red OLED 2802 to any other OLEDs of a different color. It should also be understood that the distance between two OLEDs is referred to as the distance between the geometric centers of the two OLEDs in this present disclosure.

FIG. 28B illustrates another subpixel arrangements of red, blue, and green OLEDs, according to an embodiment. Different from subpixel groups 2800, 2900, 3000, and 3100, as shown in FIG. 28B, subpixel group 2850 includes two blue ("B") OLED 2852 and 2854, one red ("R") OLED 2856, and two green ("G") OLEDs 2858 and 2860. In this embodiment, subpixel groups 2850 are repeated horizontally in the same row and are staggered relative to subpixel groups 2850 in the adjacent row by half of the width of subpixel group 2850. In each subpixel group 2850, red OLED 2856 is positioned at the upper left side, two blue OLEDs B 2852 and 2854 are positioned at the upper right side, green OLED 2858 is positioned at the lower left side, and green OLED 2860 is positioned at the lower right side. In some embodiments, green OLED 2858 aligned with the middle point of red OLED 2856 and blue OLEDs 2852 and 2854 along the vertical direction, and green OLED 2860 is aligned with the middle point of blue OLEDs 2852 and 2854 and the red OLED in the adjacent pixel group 2800 on the right.

In this embodiment, in each subpixel group 2850, the total area of two blue OLEDs 2852 and 2854 is greater than the area of each green OLED 2858/2860. In some embodiments, the area of red OLED 2856 is greater than the area of each green OLED 2858/2860. In some embodiments, the area and size of green OLEDs 2858 and 2860 are the same (or nominally the same). In some embodiments, the total area of two blue OLEDs 2852 and 2854 is the same as (or nominally the same as) the area of red OLED 2856. In some embodiments, each of the OLEDs in subpixel group 2850 has a polygonal shape. For example, as shown in FIG. 28B, blue OLEDs 2852 and 2854 may each have a hexagonal shape, blue OLED 2856 may have an octagonal shape, and green OLED 2858 and 2860 may have the same rhombus shape. However, it is understood that the shape of each subpixel in other examples may vary. Other shapes of the OLEDs include, but are not limited to, substantially round, triangle, square, pentagon, heptagon, or any other suitable shape. The regions between the OLEDs may be filled with the black matrix as noted above.

In some embodiments, in subpixel group 2850, a distance $d_{BB}$ between two blue OLEDs 2852 and 2854 is less than a minimum distance between any two of the OLEDs of different colors. For example, $d_{BB}$ may respectively be less than a distance $d_{RB}$ between blue OLED 2852 and red OLED 2856, a distance $d_{RG}$ between red OLED 2856 and green OLED 2858, a distance dBGi between green OLED 2858 and blue OLED 2852, and a distance $d_{BG2}$ between green OLED 2860 and blue OLED 2854. In some embodiments, distance $d_{BG1}$ is equal to distance $d_{BG2}$. It should be understood that because blue OLED 2854 is on the right side of blue OLED 2852, the distances between blue OLED 2854 and OLED 2856 and between blue OLED 2854 and OLED 2858 are each greater than the distance between blue OLED 2852 to these OLEDs, distance $d_{RR}$ is thus less than these distances. It should also be understood that the distance between two OLEDs is referred to as the distance between the geometric centers of the two OLEDs in this present disclosure.

In subpixel group 2800, two red OLEDs 2802 and 2804 may share the same organic light-emitting layer. In subpixel group 2850, two red OLEDs 2842 and 2844 may share the same organic light-emitting layer. For simplicity of description, the two OLEDs sharing the same organic light-emitting layer in the two figures are described together. In some embodiment, the two OLEDs (e.g., 2802 and 2804, and 2852 and 2854) have the same (or nominally the same) shape and size/area. The two OLEDs may be adjacent to and aligned with each other along the horizontal direction. In some embodiments, although not shown in the figures, the two OLEDs can be aligned along the horizontal direction and have different sizes/areas. That is, the common/shared organic light-emitting layer can be divided in any suitable ways (e.g., evenly or unevenly) to provide light to each of the two OLEDs. That is, the actual shape and size of each OLED should not be limited to the embodiments of the present disclosure. Although the two OLEDs share the same organic light-emitting layer, they are distinguishable by separate anodes and/or cathodes (e.g., referring back to the description of FIG. 5). In this example, the two OLEDs each have its respective anode and cathode for applying a current through the common/shared organic light-emitting layer. It is understood that in other examples, the two OLEDs may also share the same anode or cathode.

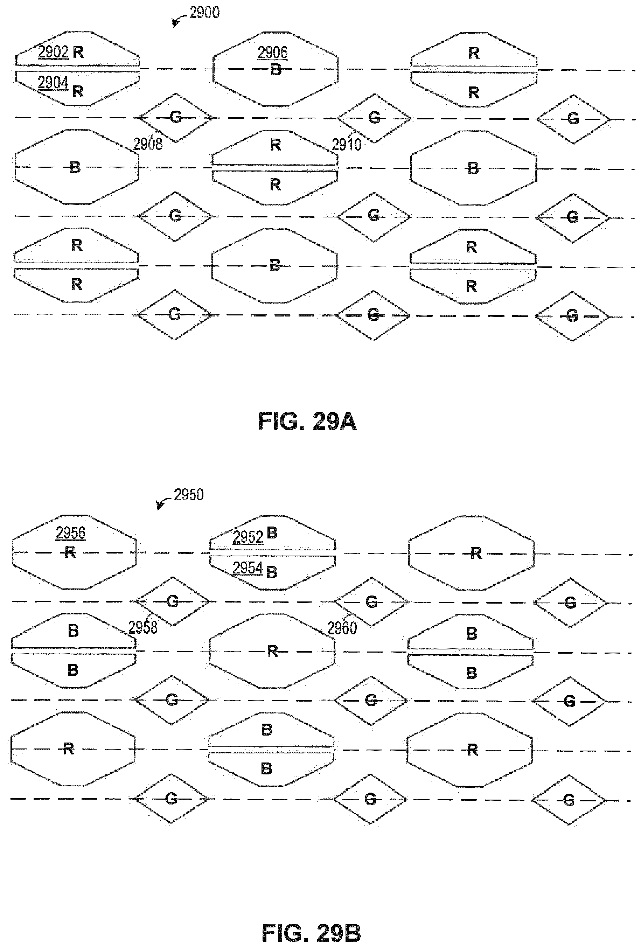

FIG. 29A illustrates a subpixel group 2900 that includes two red OLEDs 2902 and 2904, one blue OLED 2906, and two green OLEDs 2908 and 2910. FIG. 29B illustrates a subpixel group 2950 that includes two blue OLEDs 2952 and 2954, one red OLED 2956, and two green OLEDs 2958 and 2960. In some embodiments, OLEDs 2906 and 2956, 2908 and 2958, and 2910 and 2960 are similar to or the same as OLEDs 2806, 2808. and 2810, respectively, and the detailed description of these OLEDs are not repeated herein. Different from subpixel groups 2800 and 2850, two red OLEDs 2902 and 2904 may be adjacent to and aligned with each other along the vertical direction and two blue OLEDs 2952 and 2954 may be adjacent to and aligned with each other along the vertical direction. In this embodiment, the two OLEDs that share the same organic light-emitting layer (e.g., 2902 and 2904, 2952 and 2954) have the same (or nominally the same) shape (e.g., hexagonal shape) and size/area, and share the same organic light-emitting layer. In some embodiments, although not shown in the figures, the two OLEDs can be aligned along the vertical direction and have different sizes/areas. That is, the common/shared organic light-emitting layer can be divided in any suitable ways (e.g., evenly or unevenly) to provide light to each of the two OLEDs. Similar to red OLEDs 2802 and 2804, the two OLEDs can be distinguishable by separate anodes and/or cathodes. In some embodiments, similar to red OLEDs 2802 and 2804, a distance between the two OLEDs is less than a minimum distance between any two of the OLEDs of different colors. For example, the distance between red OLEDs 2902 and 2904 is respectively less than a distance between red OLED 2902/2904 and blue OLED 2906 and a distance between blue OLED 2906 and green OLED 2908/2910. In another example, the distance between blue OLEDs 2952 and 2954 is respectively less than a distance between blue OLED 2952/2954 and red OLED 2956 and a distance between red OLED 2956 and green OLED 2958/2960.

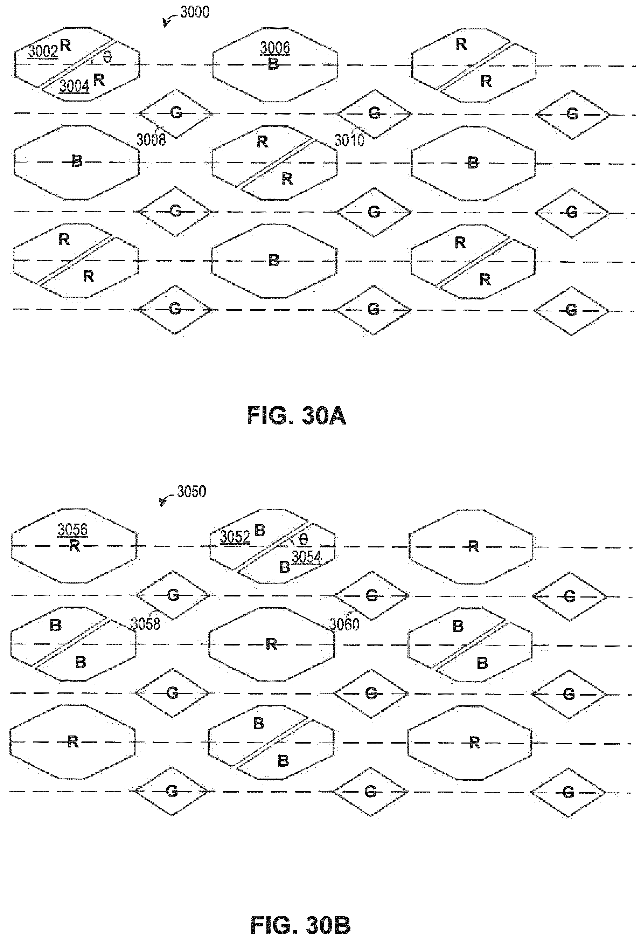

FIG. 30A illustrates a subpixel group 3000 that includes two red OLEDs 3002 and 3004, one blue OLED 3006, and two green OLEDs 3008 and 3010. FIG. 30B illustrates a subpixel group 3050 that includes two blue OLEDs 3052 and 3054, one red OLED 3056, and two green OLEDs 3058 and 3060. In some embodiments, OLEDs 3006 and 3056, 3008 and 3058, and 3010 and 3060 are similar to or the same as OLEDs 2806, 2808, and 2810, respectively, and the detailed description of these OLEDs are not repeated herein. Different from subpixel groups 2800, 2850, 2900, and 2950, the two OLEDs that share the same organic light-emitting layer (e.g., 3002 and 3004, 3052 and 3054) may be adjacent to and aligned with each other along an oblique direction. In this embodiment, the two OLEDs have the same (or nominally the same) shape (e.g., hexagonal shape) and size/area. As shown in FIGs. 30A and 30B, an oblique angle $\theta$ along which the common light-emitting layer is divided is greater than 0 degree and less than 90 degrees. In some embodiments, oblique angle $\theta$ is defined as the angle between the horizontal direction and the direction of the division of the two OLEDs. In some embodiments, although not shown in the figures, the two OLEDs can be aligned along the oblique direction and have different sizes/areas. That is, the common/shared organic light-emitting layer can be divided in any suitable ways (e.g., evenly or unevenly) to provide light to each of the two OLEDs. Similar to red OLEDs 2802 and 2804, the two OLEDs can be distinguishable by separate anodes and/or cathodes. In some embodiments, similar to red OLEDs 2802 and 2804, a distance between the two OLEDs is less than a minimum distance between any two of the OLEDs of different colors. For example, the distance between red OLEDs 3002 and 3004 is respectively less than a distance between red OLED 3002/3004 and blue OLED 3006 and a distance between blue OLED 3006 and green OLED 3008/3010. In another example, the distance between blue OLEDs 3052 and 3054 is respectively less than a distance between blue OLED 3052/3054 and red OLED 3056 and a distance between red OLED 3056 and green OLED 3058/3060.

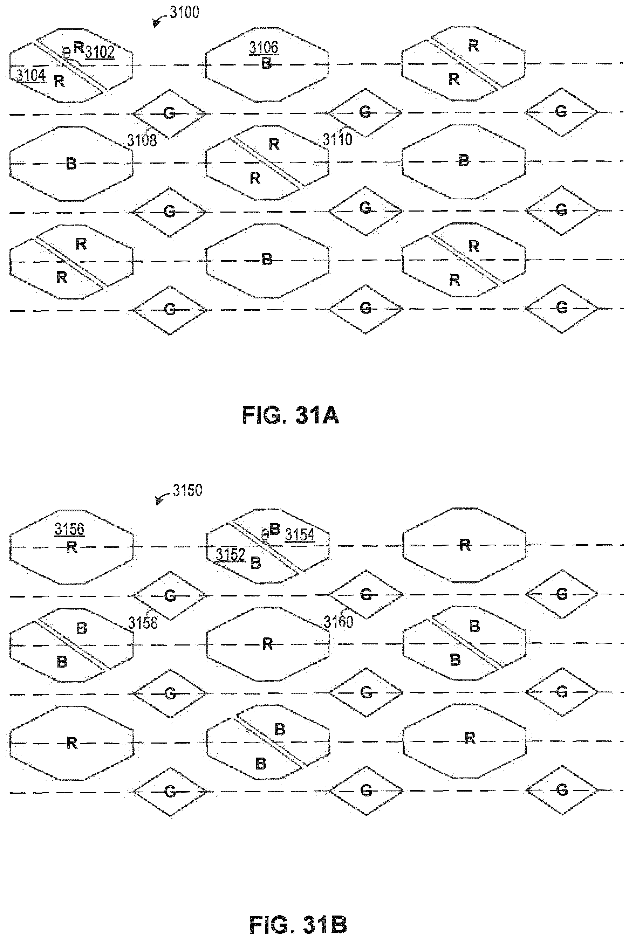

FIG. 31A illustrates a subpixel group 3100 that includes two red OLEDs 3102 and 3104, one blue OLED 3106, and two green OLEDs 3108 and 3110. FIG. 31B illustrates a subpixel group 3150 that includes two blue OLEDs 3152 and 3154, one red OLED 3156, and two green OLEDs 3158 and 3160. In some embodiments, OLEDs 3106 and 3156, 3108 and 3158, and 3110 and 3160 are similar to or the same as OLEDs 2806, 2808, and 2810, respectively, and the detailed description of these OLEDs are not repeated herein. Different from subpixel groups 2800, 2850, 2900, 2950, 3000, and 3050, the two OLEDs that share the same organic light-emitting layer (e.g., 3102 and 3104, 3152 and 3154) may be adjacent to and aligned with each other along an oblique direction with an oblique angle $\theta$ greater than 90 degrees and less than 180 degrees. In this embodiment, the two OLEDs have the same (or nominally the same) shape (e.g., hexagonal shape) and size/area. In some embodiments, although not shown in the figures, the two OLEDs can be aligned along the oblique direction and have different sizes/areas. That is, the common/shared organic light-emitting layer can be divided in any suitable ways (e.g., evenly or unevenly) to provide light to each of the two OLEDs. Similar to red OLEDs 2802 and 2804, the two OLEDs can be distinguishable by separate anodes and/or cathodes. In some embodiments, similar to red OLEDs 2802 and 2804, a distance between the two OLEDs is less than a minimum distance between any two of the OLEDs of different colors. For example, the distance between red OLEDs 3102 and 3104 is respectively less than a distance between red OLED 3102/3104 and blue OLED 3106 and a distance between blue OLED 3106 and green OLED 3108/3110. In another example, the distance between blue OLEDs 3152 and 3154 is respectively less than a distance between blue OLED 3152/3154 and red OLED 3156 and a distance between red OLED 3156 and green OLED 3158/3160.

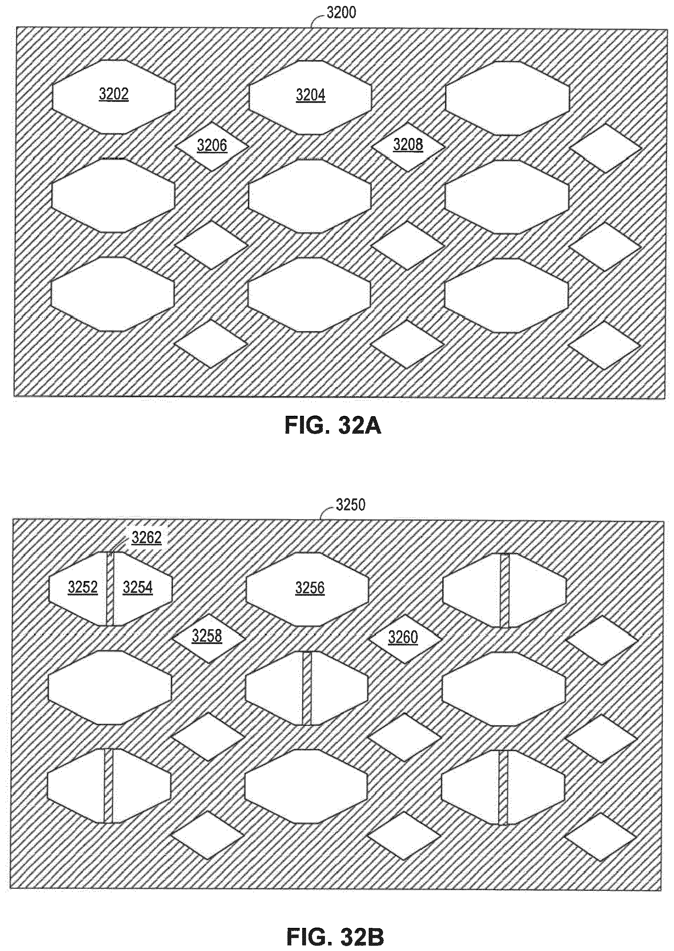

FIGs. 32A and 32B illustrate masks (e.g., FMMs) used for fabricating organic light-emitting layers of the red, green, and blue OLEDs shown in FIG. 28A. Specifically, FIG. 32A shows a mask 3200 for fabricating the organic light-emitting layers of the red, blue, and green OLEDs by evaporation technique, and FIG. 32B shows a mask 3250 for fabricating the anodes and/or cathodes of the OLEDs by evaporation technique. In FIG. 32A, openings 3202, 3204, 3206, and 3208 on mask 3200 respectively correspond to an organic light-emitting layer of two red OLEDs 2802 and 2804, blue OLED 2806, green OLED 2808, and green OLED 2810. In FIG. 32B, on mask 3250, opening 3252 corresponds to the electrodes (e.g., anodes and/or cathodes) on the red OLED 3252, opening 3254 corresponds to the electrodes on the red OLED 3254, opening 3258 corresponds to the electrodes on blue OLED 2806, opening 3258 corresponds to the electrodes on the green OLED 2808, and opening 3260 corresponds to the electrodes on the green OLED 2810.

FIG. 33A illustrates a subpixel group 3300 that includes two red OLEDs 3302 and 3304, two blue OLEDs 3306 and 3312, and two green OLEDs 3308 and 3310, in which the two red OLEDs 3302 and 3304 are aligned with each other along the horizontal direction and the two blue OLEDs 3306 and 3312 are aligned with each other along the horizontal direction. FIG. 33B illustrates a subpixel group 3350 that includes two red OLEDs 3352 and 3354, two red OLED 3356 and 3362, and two green OLEDs 3358 and 3360, in which the two red OLEDs 3352 and 3354 are aligned with each other along the vertical direction and the two blue OLEDs 3356 and 3362 are aligned with each other along the vertical direction. In some embodiments, OLEDs 3302, 3304, 3306, 3312, 3308, and 3310 are similar to or the same as OLEDs 2802, 2804, 2852, 2854, 2808, and 2810, respectively, and the detailed description of these OLEDs are not repeated herein. In some embodiments, OLEDs 3352, 3354, 3356, 3362, 3358, and 3360 are similar to or the same as OLEDs 2902, 2904, 2952, 2954, 2908, and 2910, respectively, and the detailed description of these OLEDs are not repeated herein. In some embodiments, similar to red OLEDs 2802 and 2804 and blue OLEDs 2902 and 2904, a distance between the two OLEDs sharing the same organic light-emitting layer in subpixel groups 3300 and 3350 is less than a minimum distance between any two of the OLEDs of different colors in the same subpixel group. For example, the distance between the two red OLEDs (e.g., 3302 and 3304, 3352 and 3354) is less than a minimum distance between any OLEDs of different colors, and the distance between the two blue OLEDs (e.g., 3306 and 3312, 3356 and 3362) is less than a minimum distance between any OLEDs of different colors.

In various embodiments, in the at least one subpixel, the two OLEDs (e.g., the two red OLEDs and the two blue OLEDs) sharing the same organic light-emitting layer can have any suitable arrangement. For example, the two OLEDs can have the same or different arrangement. For example, the two OLEDs can be adjacent to and aligned with each other along the horizontal direction, the vertical direction, or a respective oblique angle. The arrangement of the two OLEDs may be referred to the description of FIGs. 28A, 28B, 29A, 29B, 30A, 30B, 31A, and 31B, and the detailed description is not repeated herein. In some embodiments, a distance between the two OLEDs sharing the same organic light-emitting layer in the at least one subpixel group is less than a minimum distance between any two of the OLEDs of different colors in the same subpixel group.

Exemplary OLEDs sharing the same organic light-emitting layer and formed by the masks can be similar to the OLEDs shown in FIG. 5. The area and shape of openings 3252 and 3254 may determine the area and shape of the formed electrodes. In some embodiments, mask 3250 includes a pattern 3262 between and dividing openings 3252 and 32554. The shape, orientation, and position of pattern 3262 may determine the way the two red OLEDs 2802 and 2804 are arranged with each other, and the shape and size/area of the two red OLEDs 2802 and 2804. For example, pattern 3262 may be oriented vertically to divide the common organic light-emitting layer into the portions that are horizontally aligned with each other, each portion corresponding to a respective red OLED. A width of pattern 3262 may be related to the distance between the two red OLEDs 2802 and 2804. In other embodiments of the present disclosure, similar masks and fabrication method can be used to fabricate organic light-emitting layers of the OLEDs in other subpixel arrangements shown in, e.g., FIGs. 28B, 29A, 29B, 30A, 30B. 31A, and 31B. In the fabrication of these OLEDs, the pattern in the mask used to form the electrodes can be varied to form different shapes, sizes, and arrangement of the two OLEDs that share the same organic light-emitting layer.

In some embodiments, between the two OLEDs sharing the same organic light-emitting layer, a first distance between the anode and cathode of one OLED is different from a second distance between the anode and cathode of the other OLED. In some embodiments, the first distance is equal to (or nominally equal to) an integer multiple of a half wavelength of the color of the OLED (e.g., red or blue). In some embodiments, the second distance is different from (e.g., less than or greater than) the first distance. In some embodiments, the anode and/cathode of the OLEDs are made of reflective materials, and the difference in the distances between electrodes may enhance the light emission of OLEDs from different angles.

In some embodiments, the two OLEDs sharing the same organic light-emitting layer correspond to different capacitances. In some embodiments, the capacitances of the two OLEDs include the capacitances formed by the different sizes/areas of the two OLEDs, and/or the different distances between the respective electrodes. In some embodiments, the capacitances include the capacitances of the respective driving circuits.

Aspects of the method for subpixel rendering on a display, as outlined above, may be embodied in programming. Program aspects of the technology may be thought of as "products" or "articles of manufacture" typically in the form of executable code and/or associated data that is carried on or embodied in a type of machine readable medium. Tangible non-transitory "storage" type media include any or all of the memory or other storage for the computers, processors or the like, or associated modules thereof, such as various semiconductor memories, tape drives, disk drives and the like, which may provide storage at any time for the software programming.

All or portions of the software may at times be communicated through a network such as the Internet or various other telecommunication networks. Such communications, for example, may enable loading of the software from one computer or processor into another. Thus, another type of media that may bear the software elements includes optical, electrical and electromagnetic waves, such as used across physical interfaces between local devices, through wired and optical landline networks and over various air-links. The physical elements that carry such waves, such as wired or wireless links, optical links or the like, also may be considered as media bearing the software. As used herein, unless restricted to tangible "storage" media, terms such as computer or machine "readable medium" refer to any medium that participates in providing instructions to a processor for execution.

Hence, a machine readable medium may take many forms, including but not limited to, a tangible storage medium, a carrier wave medium or physical transmission medium. Non-volatile storage media include, for example, optical or magnetic disks, such as any of the storage devices in any computer(s) or the like, which may be used to implement the system or any of its components as shown in the drawings. Volatile storage media include dynamic memory, such as a main memory of such a computer platform. Tangible transmission media include coaxial cables; copper wire and fiber optics, including the wires that form a bus within a computer system. Carrier-wave transmission media can take the form of electric or electromagnetic signals, or acoustic or light waves such as those generated during radio frequency (RF) and infrared (IR) data communications. Common forms of computer-readable media therefore include for example: a floppy disk, a flexible disk, hard disk, magnetic tape, any other magnetic medium, a CD-ROM, DVD or DVD-ROM, any other optical medium, punch cards paper tape, any other physical storage medium with patterns of holes, a RAM, a PROM and EPROM, a FLASH-EPROM, any other memory chip or cartridge, a carrier wave transporting data or instructions, cables or links transporting such a carrier wave, or any other medium from which a computer can read programming code and/or data. Many of these forms of computer readable media may be involved in carrying one or more sequences of one or more instructions to a processor for execution.

The above detailed description of the disclosure and the examples described therein have been presented for the purposes of illustration and description only and not by limitation. It is therefore contemplated that the present disclosure cover any and all modifications, variations or equivalents that fall within the spirit and scope of the basic underlying principles disclosed above and claimed herein.

**Claims**

1. An apparatus, comprising:
   a display panel comprising an array of subpixel groups arranged in columns or rows, wherein:

   the array of subpixel groups comprises at least a subpixel group consisting of two subpixels of a first color, one subpixel of a second color, and two subpixels of a third color, and
   in the at least one subpixel group, a distance between the two subpixels of the first color is less than a distance between the two subpixels of the third color, and the distance between the two subpixels of the first color is less than a minimum distance between any two of the subpixels of different colors in the at least one subpixel group.

2. The apparatus of claim 1, wherein the distance between the two subpixels of the first color is less than a distance between the subpixel of the second color and each of the two subpixels of the first color, and/or wherein the distance between the two subpixels of the first color is less than a distance between the subpixel of the second color and each of the two subpixels of the third color.

3. The apparatus of claim 1 or 2, wherein the two subpixels of the first color are arranged adjacent to each along at least one of the row direction, the column direction, or an oblique direction.

4. The apparatus of any one of the preceding claims, wherein the two subpixels of the first color have the same size, or
wherein the two subpixels of the first color have different sizes.

5. The apparatus of any one of the preceding claims, wherein the at least one subpixel group is repeated along the row direction, and wherein optionally the array of subpixel groups consists of the same subpixel group repeated along the row direction.

6. The apparatus of any one of the preceding claims, wherein the array of subpixel groups comprises at least one second subpixel group different from the at least one subpixel group, the at least one second subpixel group being repeated along the row direction.

7. The apparatus of claim 6, wherein the array of subpixel groups comprises the at least one subpixel group repeated in odd rows and the at least one second subpixel groups repeated in even rows, each of the at least one second subpixel groups being the same.

8. The apparatus of claim 6 or 7, wherein an arrangement of the two subpixels of the first color in the at least one second subpixel groups is different from an arrangement of the two subpixels of the first color in the at least one subpixel groups.

9. The apparatus of any one of the preceding claims, wherein
the two subpixels of the first color share a same organic light-emitting layer and each comprises a respective pair of anode and cathode; and
a distance between the anode and the cathode of one of the two subpixels is different from a distance between the anode and the cathode of the other one of the two subpixels, and
wherein optionally one of the distances is equal to an integer multiple of a half wavelength of the first color.

10. The apparatus of claim any one of the preceding claims, wherein a total area of the two subpixels of the first color is greater than an area of each of the two subpixels of the third color.

11. The apparatus of claim 10, wherein an area of the subpixel of the second color is the same as the total area of the two subpixels of the first color.

12. The apparatus of any one of the preceding claims, wherein each of the subpixels of the first color, the second color, and the third color comprise a polygonal shape.

13. The apparatus of any one of the preceding claims, wherein the first color is a red color, the second color is a red color, and the second color is a blue color, or wherein the first color is a blue color, and the second color is a red color.

14. The apparatus of any one of the preceding claims, wherein the two subpixels of the first color correspond to different capacitances.

15. The apparatus of any one of the preceding claims, wherein
subpixel groups in each row of the array are repeated along the row direction; and
subpixel groups in each row of the array are staggered relative to subpixels groups in an adjacent row of the array along the column direction.

**100**

INPUT DEVICE — 112

SPEAKER — 110

PROCESSOR — 114

106 — DISPLAY DATA

MEMORY — 116

118

CONTROL LOGIC — 104

DISPLAY — 102

108 — CONTROL SIGNALS

106 — DISPLAY DATA

106 DISPLAY DATA

RECEIVER — 120

106 — DISPLAY DATA

**FIG. 1**

FIG. 2

EP 3 848 923 A1

ROW 1   ROW 2   ROW 3   ROW 4

FIG. 3

**FIG. 4**

FIG. 5

**FIG. 6**

FIG. 7

FIG. 8

FIG. 9

FIG. 10

FIG. 11

**FIG. 12**

EP 3 848 923 A1

**FIG. 13**

EP 3 848 923 A1

**FIG. 14**

FIG. 15

EP 3 848 923 A1

**FIG. 16**

**FIG. 17**

**FIG. 18**

**FIG. 19**

EP 3 848 923 A1

RECEIVE A PLURALITY PIECES OF DISPLAY DATA FOR DISPLAYING A PLURALITY OF PIXELS, EACH PIECE OF DISPLAY DATA COMPRISING 1ST, 2ND, AND 3RD COMPONENTS REPRESENTING 1ST, 2ND, AND 3RD COLORS, RESPECTIVELY 〜2002

PROVIDE CONTROL SIGNALS FOR RENDERING AN ARRAY OF SUBPIXELS ON THE DISPLAY BASED ON THE PLURALITY PIECES OF DISPLAY DATA 〜2004

FOR EACH SUBPIXEL IN THE 1ST COLOR, PROVIDE A RESPECTIVE CONTROL SIGNAL BASED ON 1ST COMPONENTS OF TWO PIECES OF DISPLAY DATA FOR DISPLAYING THE TWO PIXELS THAT SHARE THE SUBPIXEL IN THE 1ST COLOR 〜2006

**FIG. 20**

**FIG. 21**

EP 3 848 923 A1

FIG. 22

A
(e.g., BLUE)

B
(e.g., GREEN)

C
(e.g., RED)

FIG. 23

FIG. 25

FIG. 24

PRIOR ART

FIG. 26

**FIG. 27A**

EP 3 848 923 A1

**FIG. 27B**

EP 3 848 923 A1

FIG. 27C

FIG. 27D

FIG. 28A

FIG. 28B

2900

**FIG. 29A**

2950

**FIG. 29B**

**FIG. 30A**

**FIG. 30B**

FIG. 31A

FIG. 31B

3200

3202

3204

3206

3208

**FIG. 32A**

3250

3262

3252 3254

3256

3258

3260

**FIG. 32B**

FIG. 33A

FIG. 33B

Europäisches
Patentamt

European
Patent Office

Office européen
des brevets

# EUROPEAN SEARCH REPORT

**Application Number**

EP 20 15 2889

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/343284 A1 (SUN LIANG [CN]) 24 November 2016 (2016-11-24) | 1-8, 10-13,15 | INV. G09G3/3225 |
| A | * paragraph [0045] - paragraph [0109] * | 9,14 | |

TECHNICAL FIELDS
SEARCHED      (IPC)

G09G

The present search report has been drawn up for all claims

| Place of search | Date of completion of the search | Examiner |
|---|---|---|
| Munich | 11 June 2020 | Harke, Michael |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 20 15 2889

This annex lists the patent family members relating to the patent documents cited in the above-mentioned European search report.
The members are as contained in the European Patent Office EDP file on
The European Patent Office is in no way liable for these particulars which are merely given for the purpose of information.

11-06-2020

| Patent document cited in search report | Publication date | Patent family member(s) | Publication date |
|---|---|---|---|
| US 2016343284 A1 | 24-11-2016 | CN 104465714 A | 25-03-2015 |
| | | EP 3241236 A1 | 08-11-2017 |
| | | JP 6657127 B2 | 04-03-2020 |
| | | JP 2018503849 A | 08-02-2018 |
| | | KR 20160148688 A | 26-12-2016 |
| | | US 2016343284 A1 | 24-11-2016 |
| | | WO 2016107188 A1 | 07-07-2016 |

EPO FORM P0459

For more details about this annex : see Official Journal of the European Patent Office, No. 12/82